# FASCICULE DE BREVET EUROPEEN

(11) **EP 1 785 612 B1**
(45) Date de publication et mention de la délivrance du brevet: **07.11.2012**
(21) Numéro de dépôt: 06291650.7
(22) Date de dépôt: 24.10.2006
(51) Int. Cl.: F23R 3/42

(54) **Machine thermique à haut rendement**
Thermische Maschine mit hohem Wirkungsgrad
High efficiency thermal machine

(30) Priorité: 09.11.2005 FR 0511426
(43) Date de publication de la demande: 16.05.2007
(73) Titulaire: ONERA (Office National d'Etudes et de Recherches Aérospatiales), 92320 Châtillon (FR)
(72) Inventeur: Ribaud, Yves, 78830 Bonnelles (FR); Guidez, Joël, 75018 Paris (FR); Breteau, Jean-Paul, 94200 Ivry sur Seine (FR); Courvoisier, Thierry, 78610 Le Perray en Yvelines (FR); Dessornes, Olivier, 91140 Villebon sur Yvette (FR); Dumand, Clément, 91120 Palaiseau (FR)
(74) Mandataire: Cabinet Plasseraud

(56) Documents cités:
- US-A- 5 932 940
- IANCU,F. ET AL: "Feasability Study of Integrating Four-Port Wave Rotors into Ultra-Micro Gas Turbines" AIAA 2004-3581, 11 juillet 2004 (2004-07-11), - 14 juillet 2004 (2004-07-14) XP002391768 Fort Lauderdale, Florida
- RIBAUD,Y.: "Internal Heat Mixing and External Heat Losses in an Ultra Micro Turbine" IGTC2003TOKYO OS - 109, 2 novembre 2003 (2003-11-02), - 7 novembre 2003 (2003-11-07) XP008067709 Tokyo

## Description

La présente invention concerne une machine thermique à haut rendement, du type général des turbo machines, dont la puissance est comprise dans la gamme s'étendant de 10 Watts à environ 1 kW, c'est-à-dire jusqu'à la limite supérieure du domaine des ultra microturbomachines.

De telles ultra microturbomachines sont connues notamment par les brevets US 5 932 940 et US 6 392 313, auxquels on se reportera avantageusement pour toute précision à leur sujet. Ces brevets concernent des réalisations de différentes turbomachines, telles que notamment des turbines à gaz des turbocompresseurs, turbogénérateurs, turbopompes, turboréacteurs, et diverses combinaisons de ces dernières configurations, et dont les pièces constitutives sont réalisées dans un même matériau, de préférence en SiC, les différentes pièces ou parties constitutives pouvant être obtenues par les procédés de fabrication des microsystèmes électromécaniques, dits MEMS (selon l'acronyme anglo-saxon de "Micro Electro Mechanical System), et en particulier par des usinages bidimensionnels.

Les principales applications visées pour de telles micromachines thermiques, de type microturbines à gaz, sont la propulsion de microdrones, la fourniture d'énergie autonome, ou individuelle, dite embarquée, sous forme mécanique, pneumatique ou électrique, pour des robots, des systèmes portables, des microsatellites, des actionneurs, et pour le refroidissement de circuits électroniques, sans que cette liste soit limitative.

Il est en effet récemment apparu que les micromachines thermiques pouvaient supplanter les batteries en termes de puissance spécifique et d'énergie spécifique, sous réserve que leur rendement thermique soit suffisant, du fait que les différents concepts de micromachines thermiques proposées ont pour point commun que leur énergie est tirée d'une micro combustion ou réaction chimique exothermique. En effet, l'utilisation du processus de combustion pour la génération de puissance électrique présente d'énormes avantages par rapport aux batteries traditionnelles, en termes de stockage d'énergie par unité de masse, ainsi qu'en termes de génération de puissance par unité de volume. Parmi les différents types de moteurs thermiques proposés, l'ultra microturbine à gaz est particulièrement intéressante du fait de ses hautes potentialités en termes de puissance et d'énergie spécifiques.

La base des microsystèmes faisant l'objet des deux brevets US précités est une microturbine à gaz dont deux versions sont proposées, l'une avec un rotor d'un faible diamètre (4 mm) et deux disques reliés par un arbre, et l'autre au diamètre doublé et comportant deux disques accolés.

Les principaux composants de la microturbine sont une chambre de combustion, et un compresseur centrifuge et une turbine centripète qui, dans la première version, sont montés sur un même arbre creux tournant à une vitesse périphérique de l'ordre de 500 m/s. Un générateur-moteur électrique, situé au-dessus du rotor du compresseur, est chargé de la production d'énergie électrique en cours de fonctionnement, ainsi que de l'entraînement de l'arbre commun au compresseur et à la turbine lors du démarrage de la microturbine. Du combustible est injecté en aval d'un diffuseur aubé, entourant radialement la roue de compresseur, et est prémélangé au débit d'air comprimé sortant du diffuseur dans un canal centrifuge de prémélange, avant de pénétrer dans la chambre de combustion, d'où les gaz de combustion sortent par un canal centripète donnant sur le rotor de la turbine, au travers d'un distributeur aubé entourant radialement ce dernier. Le guidage de l'arbre rotor est assuré par des paliers à gaz en raison de l'importante vitesse de rotation.

Dans un exemple de réalisation, ces différents organes sont réalisés en céramique réfractaire à partir d'un empilement et alignement de six couches de SiC, chacune de ces couches étant obtenue par un procédé de microgravure ionique connu, le SiC étant utilisé plutôt que le Si en raison de son aptitude à supporter les contraintes imposées par la grande vitesse de rotation et la haute température du cycle choisi pour la microturbine à gaz, qui peut être le cycle de Brayton-Joule ou cycle classique des turbines à gaz.

Dans la deuxième version de microturbine proposée dans les deux brevets US précités, le diamètre de la microturbine est doublé (21 mm), les disques de compresseur et de turbine sont accolés par leur face opposée à l'aubage de compresseur ou de turbine correspondant, ce qui constitue une disposition favorable au plan de la réduction des pertes aérodynamiques par frottement de disque, et semble renforcer la solidité mécanique du rotor en réduisant son encombrement axial, le diamètre du disque côté turbine a été sensiblement réduit et son épaisseur augmentée, et enfin l'entrée du compresseur et l'échappement de la turbine entourent un corps central, permettant d'aménager à cet endroit un palier de poussée sous la forme d'une butée à gaz.

Des études énergétiques globales, décrites dans l'article de Y. Ribaud « Overall thermodynamic study of an ultra micro turbine, Journal of Thermal Science Vol.13, N°4, nov. 2004 », de ce type de turbomachine prenant en compte les intenses transferts thermiques internes intervenant dans de telles turbomachines et se traduisant par un mélange thermique entraînant une dégradation des performances énergétiques, ont mis en évidence que leurs concept et architecture ne sont pas favorables du point de vue aérothermodynamique.

En effet, la chambre de combustion de ces turbomachines est annulaire, aplatie axialement et enroulée sensiblement autour du rotor de la turbomachine, d'où un grand maître couple et une grande surface de contact avec les gaz de travail, d'où encore des fuites thermiques importantes entraînant des risques de combustion incomplète et des difficultés d'allumage dans la chambre de combustion. De plus, le compresseur et la turbine se comportent aussi comme des échangeurs, en particulier dans la deuxième version, dans laquelle les disques de compresseur et de turbine sont accolés, ce qui est très défavorable sous l'angle des transferts thermiques, de sorte que le réchauffage dans le compresseur nuit au taux de compression, et par conséquent abaisse la puissance utile, et simultanément le refroidissement de la turbine réduit aussi la chute d'enthalpie disponible, et donc la puissance utile. Ce mélange thermique très néfaste est d'autant plus important qu'un unique matériau très conducteur, en l'occurrence le carbure de silicium monocristal, est utilisé pour réaliser ces composants de la turbomachine. En outre, l'usinage du carbure de silicium monocristal est très difficile, et donc d'un prix de revient prohibitif au niveau industriel. Par ailleurs, le générateur électrique de type magnétique associé à ce type de turbomachine est handicapé par les fortes températures auxquelles il est soumis, et pouvant provoquer une désaimantation lorsque le point de Curie est atteint.

Partant de cette deuxième version de microturbine, il a été récemment proposé, dans un article intitulé « Micro Combustion Chambers Principles Dedicated To Micro-Turbines » de O. DESSONES, C. DUMAND, D. GAFFIE, J. GUIDEZ et Y. RIBAUD, publié dans POWERMEMS 2003 MAKUHARI, JAPAN, une version dérivée dans laquelle la chambre de combustion n'est plus enroulée autour du rotor, mais décalée axialement par rapport au rotor sous la forme d'une chambre séparée et « en volume », et non « en surface », et pouvant être réalisée séparément, par moulage ou micro usinage laser par exemple, dans une structure hybride de la microturbine.

Une telle structure hybride présente les avantages d'une adaptation possible du volume de la chambre de combustion au type de combustible utilisé, avec réduction du maîtrecouple, d'une diminution de la surface d'échange thermique avec l'extérieur, d'une utilisation possible de matériaux isolants sur certaines parties afin d'améliorer sensiblement le rendement thermique, et d'un échappement de la turbine centripète qui peut être radial, plus favorable sous l'angle énergétique que l'échappement axial dans les brevets US précités.

Toutefois, cette version dérivée ne remédie que de manière incomplète aux inconvénients précités des microturbines selon les deux brevets US précibés. Par ailleurs, l'article de Iancu, F. et al, intitulé « Feasability Study of Integrating Four-Ports Wave Rotors into Ultra-Micro Gas Turbines », AIAA 2004-3581, 11 juillet 2004 (2004-07-11), 14 juillet 2004 (2004-07-14) XP002391768, Fort Lauderdale Florida, présente une étude de faisabilité relative à l'intégration d'un compresseur-détendeur à ondes à quatre portes de types connus, dit « rotor à ondes », dans des ultra microturbines à gaz. Cet article propose trois architectures de microturbine à gaz munies de rotors à ondes (wave rotors) à quatre portes et représentées sur ses figures 5, 6 et 7. En premier, on remarque que dans les 3 architectures proposées, la chambre de combustion est annulaire et placée vers l'extérieur de la machine, comme dans l'architecture proposée dans les deux brevets US précités, et non au centre de la machine, près de l'axe de rotation des parties tournantes. Cette configuration augmente les surfaces d'échange thermique, en particulier vers l'extérieur, mais aussi vers l'intérieur, ce qui n'est pas favorable sur le plan thermodynamique et ne favorise pas l'intégration de ce système aux surfaces très chaudes dans le système récepteur (microdrone, robot..., groupe d'énergie portable).

Dans la configuration de la figure 5 de cet article, le rotor à ondes cylindrique est enroulé annulairement et dans le même plan radial, autour du disque tournant portant les aubes mobiles du compresseur centrifuge et de la turbine centripète, tandis que la chambre de combustion entoure les deux organes précédents. Du fait du grand maître couple, la hauteur axiale de passage dans le rotor à ondes est très faible, d'où des frottements et transferts thermiques exagérés entre fluides froids et chauds qui lèchent les mêmes surfaces internes au rotor à onde.

La différence entre les configurations des figures 5 et 7 de cet article provient essentiellement du fait que les positions respectives de la chambre de combustion et du rotor à ondes cylindrique annulaire sont interverties, ce qui n'altère pas les observations précédentes.

Dans le cas de la configuration de la figure 6, le rotor à ondes cylindrique est placé en dessous du disque mobile muni de ses aubes du compresseur centrifuge et de la turbine centripète, ce qui permet une configuration à maître couple diminué. Néanmoins, la chambre de combustion est toujours annulaire et placée vers l'extérieur. De plus les conduits de cheminement du fluide ne sont arrangés ni pour limiter le mélange thermique interne, ni choisis de façon à favoriser l'existence d'un cycle thermodynamique évolué (refroidissement inter-étage, réchauffage en fin de compression, utilisation de la vapeur d'eau en cycle combiné).

Le problème à la base de l'invention est de proposer une architecture de microturbomachine thermique, qui remédie aux inconvénients majeurs précités des microturbomachines selon les brevets US précités et qui convienne mieux aux diverses exigences de la pratique que les microturbomachines de l'état de la technique, en particulier en ce que l'architecture proposée, assez générale, peut être appliquée à des machines thermiques d'une puissance supérieure, de l'ordre de 10 à 300 kW, permettant ainsi de disposer d'une énergie autonome dite embarquée, sous forme mécanique, pneumatique ou électrique, l'architecture proposée permettant de préférence de plus de s'affranchir d'une réalisation en un seul matériau très conducteur et très difficile à usiner, comme le SiC, pour permettre le choix de plusieurs types de matériau (Si, céramiques, alliages métalliques), conducteurs ou isolants, suivant les fonctions remplies par les différents composants réalisés dans ces différents matériaux.

A cet effet, l'invention propose une machine thermique comprenant :
- deux rotors indépendants, préférentiellement coaxiaux, montés chacun dans l'un respectivement de deux carters, le premier rotor appartenant à un étage basse pression, le second rotor appartenant à un étage haute pression, chaque étage muni de son rotor et d'organes fixes associés de préparation de fluide combinant des moyens de compression de gaz, dits compresseur, et des moyens de détente de gaz, dits détendeur, et
- au moins une chambre de combustion caractérisée en ce que ladite au moins une chambre de combustion est située dans un volume central sensiblement cylindrique délimité
   . à ses bases, par les deux rotors et leurs carters, et
   . à sa surface latérale, par une première paroi, sensiblement cylindrique et en position radiale interne,
ladite première paroi étant sensiblement coaxiale à une deuxième paroi, sensiblement cylindrique et en position radiale intermédiaire, lesdites première et deuxième parois définissant entre elles un premier conduit reliant la sortie du compresseur de l'étage haute pression à l'entrée d'une première chambre de combustion
et ladite deuxième paroi étant sensiblement coaxiale à une troisième paroi, sensiblement cylindrique et en position radiale externe, lesdites deuxième et troisième parois définissant entre elles un second conduit, extérieur au premier conduit et reliant la sortie du compresseur de l'étage basse pression à l'entrée du compresseur de l'étage haute pression,
la sortie de la première chambre de combustion alimentant le détendeur de l'étage haute pression en gaz produits de combustion, guidés de la sortie du détendeur de l'étage haute pression à l'entrée du détendeur de l'étage basse pression, dont la sortie est en communication avec l'extérieur d'un carter de la machine par au moins une ouverture d'échappement des gaz produits de combustion.

Les avantages d'une telle architecture sont nombreux : du fait du montage de la ou des chambres de combustion dans un volume central sensiblement cylindrique de la machine, délimité entre les deux rotors et leurs carters, en direction sensiblement axiale, et, radialement, à l'intérieur de trois parois sensiblement coaxiales et cylindriques, délimitant entre elles, radialement de l'intérieur vers l'extérieur, un conduit d'un gaz, tel que l'air comprimé à haute pression, entre la sortie du compresseur de l'étage haute pression et l'entrée d'une première chambre de combustion, et un conduit dudit gaz, tel que de l'air comprimé à basse pression, entre la sortie du compresseur de l'étage basse pression et l'entrée du compresseur de l'étage haute pression, on réalise une architecture de turbomachine agencée en "cocon thermodynamique", dans laquelle les parties chaudes sont concentrées dans le volume central de la machine, ou tournées vers l'intérieur de la machine, et peuvent être au moins partiellement isolées thermiquement des parties périphériques froides par le choix de matériaux thermiquement isolants pour réaliser au moins une paroi ou un carter intermédiaire, entre des parois ou carters internes, d'une part, et externes, d'autre part, réalisés en des matériaux thermiquement conducteurs. En outre, la vitesse périphérique de chaque rotor peut être diminuée, du fait de l'adoption d'une architecture à deux étages, de sorte que les contraintes mécaniques sont allégées, et, de plus, il est plus aisé de mettre au point des paliers à gaz à ces vitesses réduites par rapport à celles des réalisations à un seul étage de l'état de la technique. Par ailleurs, l'accroissement du taux de compression, résultant de l'architecture à deux étages, est très avantageux au plan énergétique.

Plus précisément et avantageusement, le carter externe de la machine, qui comprend la troisième paroi, délimitant radialement vers l'extérieur le second conduit, annulaire et externe de circulation de gaz comprimé basse pression, est réalisé en matériau thermiquement conducteur, et, de préférence, est muni d'ailettes et/ou de picots sur sa face externe et/ou interne, tandis que le premier conduit, annulaire et interne de circulation de gaz comprimé haute pression, est délimité entre la deuxième paroi, agencée en carter intermédiaire en un matériau thermiquement isolant, radialement vers l'extérieur et le séparant du second conduit, et, radialement vers l'intérieur, la première paroi agencée en carter interne en un matériau thermiquement conducteur, le séparant de la première chambre de combustion. Ces mesures techniques améliorent le confinement des parties chaudes (chambre(s) de combustion et les deux détendeurs) de la turbo-machine dans sa partie centrale, et le maintien, à la périphérie de la machine, de parties "froides" (les moins chaudes, notamment les deux compresseurs), ce qui facilite la maîtrise de leurs températures et des flux thermiques, du fait du montage tête-bêche des deux rotors, et de la disposition d'au moins une chambre de combustion dans la partie centrale de la machine, entre les deux détendeurs disposés en vis-à-vis, alors que les deux compresseurs sont tournés vers l'extérieur de la machine.

Pour les mêmes raisons, l'échappement vers l'extérieur des gaz issus du détendeur de l'étage basse pression est avantageusement assuré par des conduits discrets rayonnant sensiblement radialement vers l'extérieur par rapport à l'axe du premier rotor.

Dans un mode préféré de réalisation, la machine thermique selon l'invention comprend deux chambres de combustion logées dans le volume central entre les deux rotors, et dont la première chambre de combustion, dite chambre de combustion principale, alimentée en gaz, tel que de l'air, comprimé à haute pression sortant du compresseur de l'étage haute pression par le premier conduit, est convergente sensiblement dans la direction de l'axe du second rotor, vers l'entrée du détendeur de l'étage haute pression, dont la sortie débouche dans l'entrée de la deuxième chambre de combustion, dite chambre de combustion secondaire, entourée par la première chambre de combustion annulaire, et qui converge axialement vers sa sortie reliée radialement vers l'extérieur à l'entrée du détendeur de l'étage basse pression, la circulation des gaz dans les deux chambres de combustion s'effectuant sensiblement axialement à contresens.

On réalise ainsi une machine thermique à très haut rendement, avec deux chambres de combustion, dont l'une entoure l'autre, et toutes deux situées entre les détendeurs des deux rotors et leurs carters, et à l'intérieur des trois parois sensiblement coaxiales et cylindriques, dont la paroi intermédiaire est avantageusement thermiquement isolante, les deux chambres de combustion étant parcourues à contre-courant par les gaz produits de combustion, ce qui améliore encore leur contrôle en température. A cet effet, les deux chambres de combustion sont avantageusement séparées l'une de l'autre par une cloison centrale sensiblement conique en un matériau thermiquement conducteur et conformée de sorte à délimiter les convergents à contre-courant des deux chambres de combustion.

Toujours dans le but d'améliorer l'équilibre thermique de la machine selon l'invention, des conduits d'échappement vers l'extérieur des gaz d' échappement issus du détendeur de l'étage basse pression sont avantageusement délimités entre deux parois internes sensiblement radiales et thermiquement isolantes, dont l'une entoure la sortie du détendeur de l'étage basse pression tandis que la seconde dévie radialement vers l'extérieur les gaz produits de combustion issus de ladite au moins une chambre de combustion et du détendeur de l'étage haute pression.

De plus, dans l'architecture dite en "cocon thermodynamique" de la machine thermique selon l'invention, cette dernière est avantageusement telle que le rapport de ses dimensions sensiblement radiale et axiale par rapport à l'axe de l'un au moins des rotors est voisin de 1.

Dans un mode préféré de réalisation, l'étage basse pression comporte le premier rotor qui comprend, sur une face tournée vers l'extérieur de la machine, une roue aubée de compresseur centrifuge qui tourne radialement à l'intérieur d'un diffuseur annulaire à aubes fixes par rapport au carter du premier rotor, et, sur la face interne du rotor, une roue aubée de turbine centripète, qui tourne radialement à l'intérieur d'un distributeur annulaire centripète à aubes fixes par rapport au carter du premier rotor, les roues de compresseur et de turbine étant solidaires en rotation autour de leur axe commun, qui est l'axe du premier rotor.

Dans ce cas, et selon une première variante de réalisation, l'étage haute pression présente une architecture analogue à celle de l'étage basse pression, les deux étages se présentant tête bêche, l'étage haute pression comportant le second rotor qui comprend, sur une face tournée vers l'extérieur de la machine, une roue aubée de compresseur centrifuge qui tourne radialement à l'intérieur d'un diffuseur annulaire à aubes fixes par rapport au carter du second rotor, et, sur la face interne du rotor, une roue aubée de turbine centripète, qui tourne radialement à l'intérieur d'un distributeur annulaire centripète à aubes fixes par rapport au carter du second rotor, les roues de compresseur et de turbine étant solidaires en rotation autour de leur axe commun, qui est l'axe du second rotor.

On réalise ainsi une turbomachine avec un étage turbocompresseur basse pression et un étage turbocompresseur haute pression entre lesquels la combustion d'un mélange d'un gaz, tel que de l'air, comprimé haute pression et d'un carburant est assurée dans une ou deux chambres de combustion centrales, selon un étagement à la fois radial et axial qui facilite grandement la réalisation des différents composants de la machine thermique dans des matériaux appropriés et par la mise en oeuvre de techniques de fabrication et en particulier d'usinages plus conventionnels et plus économiques que les procédés de fabrication des technologies MEMS.

Mais, selon une seconde variante, l'étage haute pression comprend un compresseur-détendeur à ondes, dit "rotor à ondes", dans lequel un transfert d'énergie entre compression d'un gaz tel que de l'air et détente de gaz brûlés s'effectue à l'intérieur d'une roue à canaux par contact direct entre ledit gaz (air) et lesdits gaz, tel que de l'air, et des gaz brûlés dans lesdits canaux et par un processus basé sur le déplacement d'ondes de détente et d'ondes de compression dans lesdits canaux de ladite roue à canaux, ledit « rotor à ondes » comportant une entrée de gaz (air) d'admission, une sortie de gaz (air) comprimé, reliée à.-une première chambre de combustion, une entrée d'admission des gaz brûlés provenant de la sortie de la première chambre de combustion, et une sortie d'échappement desdits gaz brûlés, vers une deuxième chambre de combustion le cas échéant et le détendeur de l'étage basse pression.

De tels compresseurs-détendeurs à ondes, ou rotors à ondes, encore dénommés "échangeurs de pression", sont des dispositifs dont des exemples de réalisation sont décrits dans les vieux brevets DE 485 386 et CH 225 426 et 229 280, auxquels correspondent les brevets US 2 399 394 et 2 461 186, ces dispositifs ayant fait l'objet de nombreux développements décrits dans de nombreux brevets plus récents.

Comme dans l'état de la technique, les rotors de la machine thermique selon l'invention sont avantageusement sustentés axialement et radialement par des paliers à gaz.

La machine thermique selon l'invention et telle que définie à ce point de la description peut constituer le coeur d'un système plus complexe combinant, par exemple, une microturbine à gaz, du type à cycle combiné, à un turbogénérateur et à un démarreur, qui peut être à propergol solide et/ou électrique, avec une résistance chauffante.

Dans ce cas, le carter de la machine délimitant, radialement ou à l'extérieur, le second conduit peut être au moins partiellement plongé dans un réservoir d'eau fermé étanche, de préférence à double paroi, destiné à la production de vapeur sous pression, et à isoler thermiquement la machine thermique de l'extérieur et faciliter son intégration dans un réceptacle qui lui est destiné.

Avantageusement, dans cette machine thermique à cycle combiné, la vapeur d'eau produite dans une première chambre de réservoir a sa pression contrôlée par une soupape de communication avec une deuxième chambre du réservoir, elle-même en communication avec l'entrée du détendeur de l'étage basse pression, de sorte à mélanger de la vapeur d'eau aux gaz produits de combustion issus de ladite au moins une chambre de combustion, avant leur passage dans le détendeur de l'étage basse pression.

Dans cette machine thermique à cycle combiné, l'échappement des gaz et de la vapeur d'eau issus du détendeur de l'étage basse pression s'effectue par des conduits séparés, de préférence rayonnant sensiblement radialement, et prolongés au travers du réservoir d'eau avant de déboucher dans le milieu ambiant, de sorte à assurer un préchauffage de l'eau dans le réservoir.

En outre, que cette machine thermique soit à cycle combiné ou non, le débit de gaz (air) issu du compresseur de l'étage basse pression peut être partagé en deux flux, dont l'un est dirigé vers le compresseur de l'étage haute pression et l'autre vers une utilisation, sous forme pneumatique, de la puissance utile.

Dans ce cas, pour obtenir une turbomachine thermique associée à un turbogénérateur, le flux de gaz (air) comprimé basse pression, correspondant à la puissance utile transmise par le compresseur de l'étage basse pression, alimente une turbine d'un turbo générateur, dont la génératrice électrique alimente une batterie, reliée par au moins une sortie de puissance électrique à au moins un consommateur électrique.

Avantageusement dans ce cas, le turbo générateur électrique est isolé thermiquement du carter de machine enveloppant les deux rotors, ladite au moins une chambre de combustion et les conduits de circulation de gaz (air) basse pression et haute pression et gaz produits de combustion basse pression et haute pression.

Dans un exemple préféré de réalisation, la génératrice électrique du turbo générateur est de type magnétique, comportant au moins un aimant permanent monté sur une face d'une roue aubée de turbine centripète du turbo générateur, du côté opposé à la face présentant les aubes de la dite turbine centripète, ledit au moins un aimant permanent étant solidaire en rotation de la roue de turbine centripète du turbo générateur et tournant en regard d'au moins une bobine plate d'induit de la génératrice électrique.

Pour assurer le fonctionnement et le démarrage de la turbomachine, et selon un premier mode de réalisation, la batterie alimentée par la génératrice électrique du turbo générateur alimente elle-même au moins un allumeur électrique du mélange gaz (air)-combustible dans ladite au moins une chambre de combustion, dans laquelle du combustible est injecté par au moins un conduit d'alimentation en combustible.

Dans le cas où la machine thermique a son carter externe au moins partiellement plongé dans un réservoir d'eau fermé étanche, la batterie alimentée par la génératrice électrique du turbo générateur peut elle-même alimenter au moins une résistance chauffante disposée dans une chambre du réservoir d'eau, pour produire de la vapeur d'eau sous pression alimentant le détendeur de l'étage basse pression pour démarrer la machine thermique à démarreur électrique à résistance chauffante.

En variante, le flux de gaz (air) comprimé basse pression provenant du compresseur de l'étage-basse pression alimente la turbine centripète du turbo générateur après ouverture d'un clapet, et de préférence au travers d'un distributeur annulaire centripète à aubes fixes entourant la roue aubée de ladite turbine centripète du turbo générateur, ou au travers d'une volute entourant ladite turbine centripète du turbo générateur.

Lorsque la machine thermique selon l'invention est équipée d'un démarreur à propergol solide, le démarreur est agencé en générateur de gaz par allumage, de préférence électrique, à partir d'une batterie, du propergol solide, de sorte qu'un flux de gaz résultant de la combustion du propergol solide est dirigé, par au moins une entrée dans une face radiale d'extrémité du carter de machine, de préférence autour d'une ouverture d'entrée de gaz (air) d'admission dans la machine thermique, de sorte à entraîner la rotation du rotor de l'étage basse pression.

Avantageusement dans ce cas, le démarreur agencé en générateur de gaz reçoit une cartouche de propergol solide mise en place pour chaque démarrage de la machine thermique, ledit générateur de gaz étant relié à l'intérieur du carter de la machine thermique par au moins une entrée quasi-tangentielle de sorte à entraîner en rotation le rotor de l'étage basse pression.

D'autres caractéristiques et avantages de l'invention ressortiront de la description donnée ci-dessous, à titre non limitatif, d'exemples de réalisation décrits en référence aux dessins annexés sur lesquels :
- la figure 1 est une vue schématique en coupe axiale d'une microturbine à gaz selon l'invention,
- la figure 2 est une vue schématique en coupe axiale d'une machine thermique dont le coeur est constitué d'une microturbine à gaz analogue à celle de- la figure 1, implantée dans un réservoir d'eau et fonctionnant selon un cycle combiné à gaz produits de combustion et vapeur d'eau, équipée d'un démarreur électrique et/ou à propergol solide, et associée à un turbogénérateur,
- la figure 3 est une vue analogue à la figure 1 d'une variante de réalisation de la microturbine à gaz, dont l'étage haute pression est constitué d'un compresseur-détendeur à ondes ou rotor à ondes, et
- la figure 4 est une vue schématique en coupe transversale du rotor à ondes radial pouvant être utilisé comme étage haute pression dans la variante de microturbine de la figure 3.

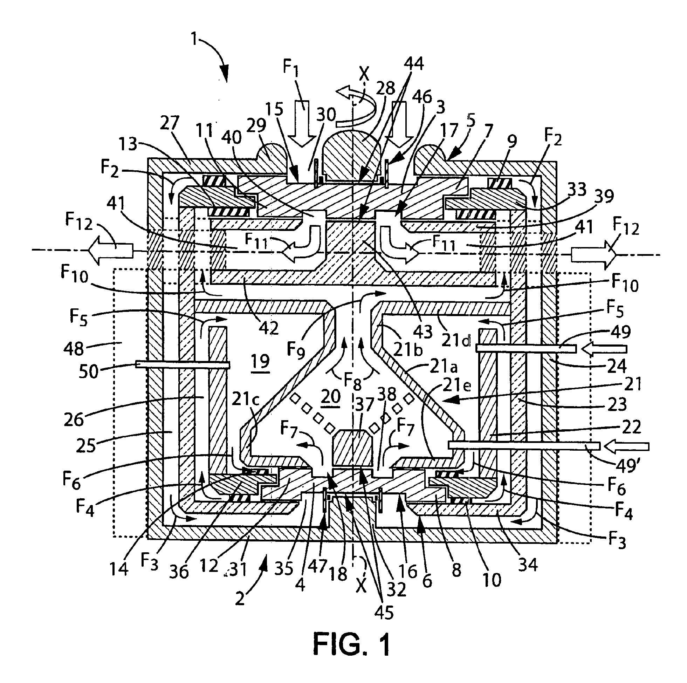

La machine thermique représentée sur la figure 1 est une microturbine à gaz dite « en volume » ou « en cocon thermodynamique », qui comprend deux étages 1 et 2, de même configuration générale, dont un étage basse pression (BP) 1 et un étage haute pression (HP) 2 situés au niveau des deux bases d'un volume cylindrique occupé par la microturbine.

Chaque étage 1 ou 2 comprend un rotor respectivement 3 ou 4, monté en rotation autour de son axe indépendamment de l'autre rotor.

Dans cet exemple, les deux rotors BP 3 et HP 4 sont coaxiaux autour de l'axe XX, mais les axes des deux rotors peuvent être latéralement décalés l'un de l'autre et/ou inclinés légèrement l'un sur l'autre dans des variantes de réalisation.

Chaque rotor 3 ou 4 est monté rotatif dans un carter respectif BP 5 ou HP 6, dont la structure est précisée ci-dessous.

Chaque rotor 3 ou 4 comprend, sur une face tournée du côté opposé à l'autre rotor 4 ou 3, c'est-à-dire sur sa face tournée vers l'extérieur de la machine, une roue aubée de compresseur centrifuge BP 7 ou HP 8, qui tourne radialement à l'intérieur d'un diffuseur annulaire centrifuge respectif 9 ou 10, à aubes fixes sur le carter 5 ou 6 correspondant.

Sur sa face opposée, tournée du côté de l'autre rotor ou vers l'intérieur de la machine, ou face interne, chaque rotor 3 ou 4 comprend une roue aubée de turbine centripète respective BP 11 ou HP 12, qui tourne radialement à l'intérieur d'un distributeur annulaire centripète respectif 13 ou 14, à aubes fixes sur le carter 5 ou 6 correspondant, de sorte que les deux étages 1 et 2 et les deux rotors 3 et 4 se présentent tête bêche.

Chaque étage BP 1 ou HP 2 comprend ainsi des moyens de compression de gaz, qui sont un compresseur centrifuge BP 15 ou HP 16, associés à des moyens de détente de gaz, qui sont une turbine centripète BP 17 ou HP 18 correspondante, dont les roues aubées 7 et 11 ou 8 et 12 sont d'une seule pièce avec le rotor BP 3 ou HP 4 correspondant, et donc solidaires en rotation autour de leur axe commun XX, chaque étage BP 1 ou HP 2 associant son rotor BP 3 ou HP 4 à des organes fixes de préparation de fluide (diffuseur 9 ou 10 et distributeur 13 ou 14) dans son carter 5 ou 6.

Entre les étages BP 1 et HP 2, au moins une chambre de combustion est aménagée dans le volume central sensiblement cylindrique de la machine. Dans cet exemple préféré de réalisation, le volume central réservé à la combustion loge deux chambres de combustion coaxiales autour de l'axe XX, et axialement tête-bêche, dont une première chambre de combustion annulaire 19, dite principale, qui entoure l'autre chambre de combustion, centrale, dite secondaire 20, séparée de la chambre de combustion principale 19 par une cloison centrale 21, en un matériau thermiquement conducteur, et de forme sensiblement tronconique dans sa partie axiale centrale 21a, entre deux parties d'extrémité axiale cylindriques 21b et 21c, de sorte à conformer les deux chambres de combustion 19 et 20 en convergents axialement à contre-sens, de leur entrée respective vers leur sortie respective.

Les deux chambres de combustion 19 et 20 sont isolées thermiquement du milieu ambiant par les deux étages BP 1 et HP 2, en direction axiale, et, en direction radiale, et de l'intérieur vers l'extérieur, par trois parois 22, 23 et 24, sensiblement cylindriques et coaxiales autour de l'axe XX, dont la 1^{ère} et la 3^{éme}, à savoir les parois interne 22 et externe 24, sont chacune en un matériau thermique conducteur, et la 2^{ème}, la paroi intermédiaire 23, est en un matériau thermiquement isolant.

Les parois externe 24 et intermédiaire 23 délimitent entre elles un conduit annulaire externe 25 de circulation d'un gaz, dans cet exemple de l'air comprimé BP de la sortie, en position radiale externe, du diffuseur 9 du compresseur centrifuge 15 de l'étage BP 1 à l'entrée, annulaire axiale et en position radiale interne, du compresseur centrifuge 16 de l'étage HP 2, tandis que les parois intermédiaire 23 et interne 22 délimitent entre elles un conduit annulaire interne 26 (radialement à l'intérieur du conduit externe 25) pour la circulation du même gaz, donc de l'air comprimé HP de la sortie du diffuseur 10 du compresseur centrifuge 16 de l'étage HP 2 à l'entrée, annulaire et radiale, de la chambre de combustion principale 19, cette entrée étant délimitée entre l'extrémité libre (vers l'étage BP 1) de la paroi interne 22 et une paroi radiale annulaire 21d en regard, solidaire de l'extrémité de la partie axiale cylindrique 21b de la cloison centrale 21 et dans le même matériau thermiquement conducteur que cette cloison 21, la paroi radiale 21d prenant appui par sa périphérie contre l'intérieur de la paroi intermédiaire 23 en limitant axialement la chambre de combustion principale 19.

A cet effet, la paroi cylindrique externe 24 est solidaire, à une extrémité axiale, d'une paroi radiale annulaire 27, dans le même matériau thermiquement conducteur que la paroi 24, et qui constitue la paroi externe du carter BP 5, et présente un corps central 28, en saillie vers l'extérieur, délimitant avec un bourrelet 29 périphérique également en saillie vers l'extérieur, une entrée annulaire axiale 30 du compresseur BP 15, pour le gaz d'admission (de l'air). A son extrémité axiale opposée, la paroi cylindrique externe 24 est également solidaire d'une paroi radiale 31, en forme de disque circulaire, également dans le même matériau thermiquement conducteur que la paroi 24 et qui présente un corps central 32, en saillie vers l'intérieur de la machine, cette paroi 31 fermant axialement vers l'extérieur le carter HP 6, de sorte que l'ensemble des trois parois externes 24, 27 et 31 constitue le carter extérieur de la machine.

La paroi cylindrique intermédiaire 23, en un matériau thermiquement isolant, est solidaire, à son extrémité axiale du côté de l'étage BP 1, d'un flasque radial annulaire 33, constituant une partie axialement intermédiaire du carter BP 5 qui entoure la partie centrale du rotor BP 3, et qui supporte les aubes fixes du diffuseur 9 et du distributeur 13 de l'étage BP 1, tandis qu'à son extrémité axiale opposée, la paroi 23 est solidaire d'une paroi radiale annulaire 34, qui constitue la paroi axialement externe du carter HP 6 et délimite une entrée annulaire axiale 35 du compresseur HP 16, autour du corps central 32 de la paroi axiale externe 31 du carter externe de la machine. Ainsi, la paroi intermédiaire 23 constitue avec le flasque radial 33 et la paroi radiale 34 un carter intermédiaire thermiquement isolant.

La paroi cylindrique interne 22 thermiquement conductrice, dont l'extrémité axiale vers l'étage BP 1 délimite, avec la paroi radiale thermiquement conductrice 21d en regard, l'entrée de la chambre de combustion principale 19 comme décrit ci-dessus, est solidaire par son extrémité axiale opposée d'un flasque radial annulaire 36, analogue au flasque 33, et qui constitue ainsi une partie axialement intermédiaire du carter HP 6, qui entoure la partie centrale du rotor HP 4, et supporte les aubes fixes du diffuseur 10 et du distributeur 14 de l'étage HP 2. De la sorte, la paroi interne 22 constitue, avec le flaque 36, un carter interne thermiquement conducteur, enveloppant les chambres de combustion 19 et 20.

Le carter HP 6 comprend également, axialement vers l'intérieur de la machine, une paroi radiale annulaire 21e thermiquement conductrice, solidaire de l'extrémité axiale de la partie cylindrique 21c de la cloison centrale 21 séparant les chambres de combustion 19 et 20 l'une de l'autre, cette paroi annulaire 21e délimitant, autour d'un corps central thermiquement conducteur 37 supporté par la cloison centrale 21 et dans le prolongement axial du corps central 32, la sortie annulaire axiale 38 de la turbine HP 18, qui constitue simultanément l'entrée axiale de la chambre de combustion secondaire 20.

Le carter BP 5 est également complété, axialement vers l'intérieur, par une paroi radiale annulaire 39, qui est thermiquement isolante, et entoure la sortie 40 annulaire axiale de la turbine BP 17, en communication avec l'extérieur du carter externe 24-27-31 de la machine par des ouvertures d'échappement réalisées sous la forme de conduits 41 discrets, rayonnant sensiblement radialement vers l'extérieur par rapport à l'axe XX, et délimités entre la paroi radiale interne 39 et une autre paroi radiale interne 42, thermiquement isolante, qui, d'une part, est solidaire d'un corps central interne 43 thermiquement isolant, dans le prolongement axial du corps central externe 28, et, d'autre part, délimite avec la paroi radiale 21d un conduit radial qui dévie radialement vers l'extérieur les gaz produits de combustion sortant axialement de la chambre de combustion secondaire 20. A noter que l'espace radial entre les parois thermiquement isolantes 39 et 42 peut être subdivisé en conduits radiaux 41 par des nervures solidaires de la paroi 42 et du corps central 43, et que les conduits d'échappement 41 se prolongent par des manchons, non représentés, mais repérés sur la figure 1 par des pointillés, qui traversent radialement les carters intermédiaire et externe de la machine, et plus précisément les parois cylindriques intermédiaire 23 et externe 24, pour déboucher à l'extérieur de la machine.

A noter également que les rotors BP 3 et HP 4 sont sustentés axialement et radialement par des paliers à gaz, tels que deux butées à gaz 44 entre le rotor 3 et les corps centraux 28 et 43, ainsi que deux butées à gaz 45 entre le rotor 4 et les corps centraux 32 et 37, pour la sustentation axiale, et les paliers aérodynamiques schématisés en 46 et 47 pour sustenter radialement les rotors 3 et 4 respectivement autour des corps centraux 28 et 32, ces différents paliers à gaz étant soit auto-alimentés (paliers hydrodynamiques) ou alimentés en air comprimé (paliers hydrostatiques) prélevé sur la sortie d'au moins un compresseur, de préférence le compresseur HP 16, et guidé jusqu'à ces paliers par des petits canaux (non présentés) ménagés dans les épaisseurs des parois. Ces paliers à gaz 46 et 47 peuvent être avantageusement, et comme connu en soi, des paliers lisses, à feuilles ou à patins oscillants, tandis que les butées axiales à gaz 44 et 45 peuvent être de type hydrostatique ou hydrodynamique, et de préférence à rainures spirales, pour leur simplicité de construction et leur efficacité.

Le circuit des gaz dans cette microturbine à gaz, dont le diamètre hors-tout est d'environ 15mm et dont le rapport des dimensions radiale et axiale est voisin de 1, est le suivant, le gaz d'admission étant de l'air ambiant.

L'air extérieur est aspiré par l'entrée annulaire 30 (voir flèches F1) du compresseur centrifuge BP 15, du fait de la rotation de la roue de compresseur BP 7 du rotor BP3, et cet air d'admission passe dans cette roue 7 puis dans le diffuseur aubé 9, et après cette première compression (flèches F2), l'air comprimé BP est dirigé (flèches F3) vers l'entrée annulaire 35 du compresseur HP 16 par le conduit externe d'air comprimé BP 25, dans lequel cet air peut être refroidi avantageusement si la surface interne et/ou la surface externe de la paroi cylindrique externe 24 du carter de machine est équipée d'ailettes ou de picots ou d'organes radiateurs analogues, comme schématisé en pointillés par les ailettes 48 en saillie sur la face externe de la paroi externe 24. Comme la paroi intermédiaire 23 délimitant le conduit d'air comprimé BP 25 est thermiquement isolante, cette paroi 23 évite que l'air comprimé BP ne soit réchauffé par des gaz et composants chauds ou réchauffés à l'intérieur de cette paroi 23.

L'air comprimé BP parvenu à l'entrée 35 du compresseur centrifuge HP 16 traverse ensuite la roue de compresseur HP 8 correspondante, puis passe dans le diffuseur 10 et, après cette seconde compression, (flèches F4) l'air comprimé HP est canalisé par le conduit interne 26 (flèches F5) jusqu'à l'entrée de la chambre de combustion principale 19, dans laquelle l'air comprimé HP est mélangé à du combustible (carburant ou hydrogène) injecté dans cette chambre de combustion 19 par un ou plusieurs tubes d'alimentation en combustible, tels que le tube radial 49, avant la combustion de ce mélange commandée par un allumeur 50, de type électrique, qui, comme le tube d'alimentation en combustible 49, traverse radialement les parois 24, 23 et 22, depuis l'extérieur de la machine, pour déboucher dans la chambre de combustion principale 19. Le fait que le carter interne ou la paroi interne 22, qui sépare le conduit interne 26 d'amenée d'air comprimé HP de la chambre de combustion principale 19, est réalisé en un matériau thermiquement conducteur présente le double avantage de refroidir ce matériau tout en préchauffant l'air comprimé HP canalisé dans le conduit 26 avant son introduction dans la chambre à combustion principale 19 délimitée par les paroi 22 et cloison 21 thermiquement conductrices. Les gaz produits de combustion dans la chambre 19 sont guidés par le convergent autour de la partie de cloison tronconique 21a (flèches F6) vers l'entrée du distributeur 14 de la turbine HP 18, puis passent dans la roue de turbine centripète HP 12 dans laquelle ils sont détendus, et ces gaz brûlés qui s'échappent du détendeur de l'étage HP 2 par la sortie annulaire 38 débouchent dans l'entrée de la chambre de combustion secondaire 20 (flèches F7) et entrent dans le volume tronconique délimité par la cloison centrale 21a, qui converge axialement vers la sortie de la chambre secondaire 20 (flèches F8), d'où les gaz produits de combustion sont guidés (flèches F9) par le conduit radial délimité entre les parois 21d et 42 puis axialement (flèches F10) à l'intérieur de la paroi intermédiaire 23 jusqu'à l'entrée radiale externe du distributeur 13 de la turbine centripète BP 17, dont la roue 11 et le rotor BP 3 sont entraînés en rotation par les gaz produits de combustion qui se détendent, puis s'échappent de l'étage BP 1 par la sortie annulaire axiale 40 de la turbine 17 (flèches F11) et ensuite par les conduits d'échappement radiaux 41 vers l'extérieur du carter de la machine (flèches F12).

La présence de la chambre de combustion secondaire 20, dont le volume tronconique est délimité par la cloison centrale 21, est avantageuse, car elle permet de réchauffer les gaz produits de combustion provenant de la sortie de la chambre de combustion principale 19 et qui se sont refroidis au cours de leur détente dans la turbine HP 18, afin de récupérer plus de puissance dans la turbine BP 17. A cet effet, la chambre de combustion secondaire 20 est alimentée en combustible par un ou plusieurs tubes d'alimentation tels que le tube radial 49', analogue au tube 49 d'alimentation en combustible de la chambre principale 19, mais débouchant à proximité de l'entrée de la chambre de combustion secondaire 20, au travers non seulement des parois 24, 23 et 22, mais également de la paroi cylindrique 21c, la combustion dans cette chambre secondaire 20 du mélange du combustible introduit par le tube 49' et des gaz sortant de la turbine HP 18 étant assurée soit par auto allumage, en raison de la grande température des gaz sortant de la turbine HP18, soit grâce à un autre allumeur (non représenté), analogue à l'allumeur 50 prévu pour la chambre de combustion principale 19, et traversant également les parois 24, 23, 22 et 21c pour que son extrémité débouche dans la chambre de combustion secondaire 20, à une faible distance en aval de l'extrémité du tube d'alimentation en combustible 49', les gaz de combustion dans les chambres de combustion 19 et 20 circulant ainsi à contre courant, ce qui s'ajoute aux autres mesures techniques d'architecture, de structure et de choix des matériaux pour concourir à un excellent contrôle des flux thermiques dans cette microturbine à gaz, dont le rendement est en conséquence élevé. En effet, les éléments de structure (parois 23, 34, 39, 42, flasque 33 notamment) séparant les parties froides (roues de compresseur 7, 8 et parois 24, 27, 31) des parties chaudes (chambres de combustion 19, 20, paroi 22 et cloison 21, et roues de turbine 11, 12) sont chacun en un matériau thermiquement isolant, alors qu'à l'inverse, les éléments de structure propres à une seule partie, qu'elle soit froide ou chaude, sont chacun en au moins un matériau thermiquement conducteur, ce qui favorise les propriétés aérodynamiques de la turbomachine, en favorisant le refroidissement par rayonnement et/ou conduction et/ou convection du carter externe 24-27-31 de la turbomachine et des deux roues de compresseur 7, 8, tout en favorisant le maintien de la température dans les parties chaudes dans le volume central de la turbomachine.

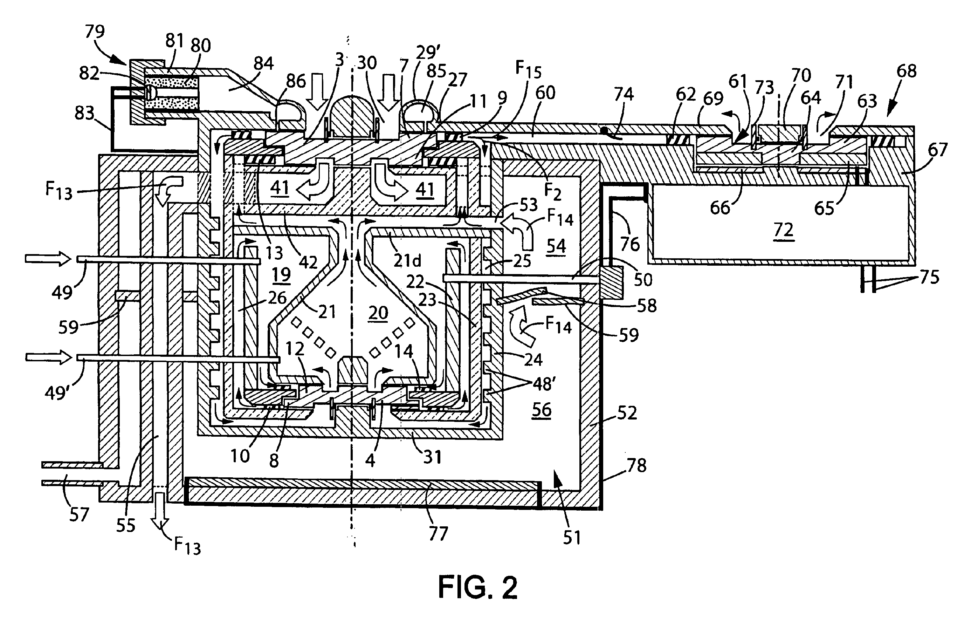

La figure 2 représente une réalisation de microturbine à gaz « en volume » ou « en cocon thermodynamique » plus complète et plus efficace sous l'angle énergétique, selon une disposition qui est, en principe, réservée à des applications terrestres, pour lesquelles le critère principal n'est pas le poids de l'installation, mais le bon niveau de rendement énergétique.

Dans cette réalisation, le carter externe 24-27-31 de la microturbine est plongé, sur la majeure partie de sa hauteur axiale, dans un réservoir d'eau 51, fermé étanche, à enveloppe externe 52 thermiquement isolante et avantageusement à double paroi, de sorte que seule la partie du carter externe qui entoure le carter 5 de l'étage BP 1 soit saillante au-dessus de la paroi supérieure de l'enveloppe externe 52 du réservoir 51. La microturbine partiellement immergée dans le réservoir 51 est sensiblement identique à celle de la figure 1, sauf sur trois points, dont l'un est que la face interne de la paroi cylindrique externe 24 est pourvue de picots radiateurs 48' à la place des ailettes de refroidissement 48 sur la face externe de cette paroi 24 sur la figure 1. Une autre différence est que le bourrelet externe 29 entourant l'entrée d'air 30 dans l'étage BP 1 sur la figure 1 est aménagé, dans la réalisation de la figure 2, en canal 29' d'alimentation en gaz d'un dispositif démarreur, décrit ci-après, pour assurer le démarrage de la microturbine. La troisième différence notable est qu'une entrée latérale 53 est ménagée par un petit conduit sensiblement radial au travers des parois cylindriques externe 24 et intermédiaire 23 et du conduit d'air comprimé BP 25, de sorte à mettre en communication l'intérieur d'une chambre annulaire supérieure 54 du réservoir 51 avec une partie de la périphérie radiale externe du conduit radial délimité, dans la microturbine, entre les parois radiales 21d et 42, les parties et composants de la microturbine de la figure 2 qui sont identiques aux parties et composants correspondants de la microturbine de la figure 1 étant repérés par les mêmes indices de référence et n'étant pas à nouveau décrits.

Dans la réalisation de la figure 2, les gaz d'échappement issus de la turbine BP 17 par les conduits sensiblement radiaux 41 de la microturbine sont dirigés vers l'atmosphère ambiante (flèches F13) à l'aide de conduits séparés 55 traversant le réservoir 51, et dont un seul est représenté sur la figure 2 et s'étend verticalement de sorte à traverser non seulement la chambre annulaire supérieure 54 mais également une chambre annulaire inférieure 56 du réservoir 51, pour déboucher à l'extérieur au niveau de la paroi inférieure de son enveloppe 52. L'eau contenue dans la chambre inférieure 56 du réservoir 51 est chauffée par la microturbine par contact avec son carter extérieur 24-31 ainsi que par les conduits d'échappement 55, de sorte que cette eau, admise dans la chambre inférieure 56 du réservoir 51 par une entrée d'eau latérale inférieure 57, est transformée en vapeur d'eau sous pression. Lorsque la pression de la vapeur d'eau dans la chambre inférieure 56 est au moins égale à la pression des gaz brûlés issus de la chambre de combustion secondaire 20, une soupape 58, montée dans la cloison transversale 59 de séparation entre les chambres 54 et 56 du réservoir 51, et tarée à la pression appropriée, est ouverte de sorte que la vapeur d'eau remplit la chambre supérieure 54 et pénètre par l'ouverture latérale 53 (flèches F14) dans la microturbine, où la vapeur d'eau se mélange avec les gaz brûlés provenant de la chambre de combustion secondaire 20 avant de pénétrer dans la turbine BP 17.

Cette réalisation, à cycle thermodynamique combiné par mélange de vapeur d'eau avec les gaz produits de combustion, présente l'avantage de réduire la température des gaz produits de combustion à une température plus acceptable pour le distributeur 13 et la roue de turbine BP 11, et également d'augmenter le débit de gaz passant dans la turbine BP 17, et donc d'accroître la puissance délivrée. L'enveloppe d'eau (vapeur ou liquide) qui entoure la microturbine l'isole de l'extérieur, diminuant ainsi les pertes énergétiques et facilitant son intégration dans un réceptacle qui lui est destiné, sur un récepteur nécessitant une énergie embarquée.

En variante, les conduits d'échappement tels que 55 peuvent être prolongés vers un condenseur (non représenté) de façon à récupérer l'eau contenue dans les gaz d'éjection de la microturbine.

Concernant la forme de puissance utile délivrée par la microturbine, une puissance mécanique peut être récupérée sur un arbre (non représenté) lié au rotor BP 3 portant la roue de turbine BP 11 ou turbine de puissance, tournant à grande vitesse de rotation (plusieurs centaines de milliers de tours par minute) compte tenu de sa petite taille dans cette microturbine.

Néanmoins, la forme électrique est la plus intéressante et la mieux adaptée à l'utilisation de l'énergie utile fournie par la turbine BP 17 ou turbine de puissance.

Compte tenu des petites dimensions, on utilise avantageusement un générateur électrique de type magnétique. En effet, les générateurs électriques de type électrostatique nécessitent des entrefers beaucoup trop faibles, ce qui entraîne une dissipation beaucoup trop grande d'énergie par frottement de l'air sur des parois, et donc, en conséquence, un échauffement important. Pour ces raisons, un générateur électrique de type magnétique, dont l'entrefer est d'au moins 10µm est avantageusement utilisé, pour une puissance utile de l'ordre de 100 W. Généralement, au moins un aimant permanent est fixé sur le rotor (en général un disque mobile) et au moins un bobinage plat est fixé en regard sur un stator. Dans le cas d'une microturbine, et comme proposé dans les brevets US 5 932 940 et 6 392 313 précités, un aimant permanent peut être placé directement sur un disque solidaire des aubes du rotor du compresseur BP, les bobinages étant placés en regard sur le carter. Cependant, du fait d'un environnement chaud, le point de Curie risque d'être atteint, et donc l'aimant permanent risque de perdre ses propriétés magnétiques.

Afin de préserver un générateur électrique de type magnétique des niveaux élevés de température rencontrés au voisinage des rotors 3 et 4 de la microturbine selon l'invention, on utilise avantageusement la disposition représentée sur la figure 2 et à présent décrite.

Dans cet agencement, le compresseur centrifuge BP 15, dimensionné en conséquence, alimente, en aval de son diffuseur 9, deux circuits de gaz (de l'air) comprimé BP en parallèle. Le 1^{er}, comme sur la figure 1, alimente (flèches F2) le compresseur HP 16 par le conduit externe d'air comprimé BP 25, tandis que le 2^{nd} circuit comprend un conduit 60 débouchant hors du carter externe de la microturbine au travers de la paroi cylindrique 24, dans un prolongement pouvant être sensiblement radial du diffuseur 9, et alimente en air comprimé BP (flèche F15) une turbine centripète 61, comprenant un distributeur 62 à aubes fixes et annulaire entourant la roue de turbine centripète 63, dont les aubes sont portées sur une face d'un rotor 64 en forme de disque. Sur la face du disque rotor 64 du côté opposé aux aubes de la turbine centripète 61, un aimant permanent 65 en forme de disque annulaire est collé ou encastré sur le rotor 64 et est solidaire en rotation du rotor 64 et de la roue de turbine 63, et tourne en regard de bobinages plats d'induit 66, immobilisés dans le fond d'un évidement cylindrique ménagé dans un support 67 en un matériau thermiquement isolant, fixé latéralement en porte-à-faux sur l'enveloppe 52 du réservoir 51, et constituant une partie du carter d'un turbogénérateur 68 ainsi constitué, dont la partie complémentaire du carter est constituée par un prolongement 69 de la paroi d'extrémité axiale annulaire 27 de la microturbine. Dans cette partie 69 du carter du turbogénérateur 68, une ouverture annulaire est ménagée autour d'un corps central cylindrique 70 et constitue la sortie axiale 71 de la turbine centripète 61, le flux d'air comprimé BP parvenant à cette turbine 61 par le conduit 60 étant guidé par la face du disque rotor 64 du côté des aubes de la roue de turbine 63 et la partie de carter 69 en regard, vers l'axe de rotation du disque rotor 64, avant l'échappement de l'air détendu après passage dans cette turbine 61 par la sortie annulaire axiale 71. Les courants électriques induits dans les bobinages 66 par la rotation de l'aimant 65 sont recueillis par une batterie 72 de stockage d'énergie électrique et ses circuits électroniques associés de commande et régulation, cette batterie 72 étant supportée sous le support isolant 67, qui isole thermiquement la génératrice électrique 65-66 et la turbine 61 du turbogénérateur 68 vis-à-vis du carter 24-31 de la microturbine, enveloppant les deux rotors 3 et 4, les chambres de combustion 19 et 20, ainsi que les conduits de circulation d'air comprimé BP 25 et HP 26 et les conduits de circulation des gaz produits de combustion. Ainsi, le générateur électrique 65-66 n'est le siège que de niveaux de température modérés et garde son efficacité électrique. Comme pour les rotors 3 et 4 de la microturbine, le rotor 64 du turbogénérateur 68 est sustenté axialement et radialement par des paliers à gaz tel que le palier aérodynamique 73 schématisé autour du corps central 70 et analogue aux paliers aérodynamiques 46 et 47 de la figure 1.

De plus, l'alimentation de la turbine centripète 61 du turbogénérateur 68 par le flux d'air comprimé BP provenant par le conduit 60 du compresseur 15 de l'étage BP 1 de la microturbine peut être commandée par l'ouverture d'un microclapet 74, obturant sélectivement le conduit 60.

En variante, l'alimentation de la turbine centripète 61 peut être assurée, à partir du conduit 60, au travers d'une volute (non représentée) entourant cette turbine centripète 71, à la place du diffuseur 62 annulaire centripète à aubes fixes.

La batterie 72 peut être reliée par au moins une sortie de puissance électrique, schématisée par les deux conducteurs 75 sur la figure 2, à au moins un consommateur électrique.

Un consommateur particulier, alimenté par le conducteur 76 à partir de la batterie 72, est constitué par le ou les allumeurs électriques 50 associés à la chambre de combustion principale 19, ainsi que par les éventuels allumeurs analogues (non représentés) associés à la chambre de combustion secondaire 20.

Un autre consommateur particulier peut être une résistance chauffante 77, disposée à l'intérieur de la chambre inférieure 56 du réservoir 51, contre le fond de l'enveloppe 52, et alimentée par le conducteur électrique 78 à partir de la batterie 72, pour produire de la vapeur d'eau sous pression alimentant la turbine centripète BP 17 de la microturbine, afin de démarrer cette dernière, ainsi équipée d'un démarreur électrique à résistance chauffante.

Avantageusement cependant, le démarrage de la microturbine est réalisé à l'aide d'un dispositif pneumatique, car d'autres composants appropriés à l'entraînement en rotation du rotor BP pour démarrer la microturbine, comme un moteur électrique par exemple, sont trop sensibles à un environnement chaud.

Dans la réalisation représentée sur la figure 2, le dispositif pneumatique de démarrage est un démarreur 79 agencé en générateur de gaz par combustion d'un propergol solide, dont une cartouche 80 est mise en place dans une chambre de combustion tubulaire 81 du démarreur 79, pour chaque démarrage de la microturbine, la combustion de la cartouche 80, par exemple en un propergol dit « basse température », étant commandée par un allumeur 82 électrique ou pyrotechnique à déclenchement électrique, logé au fond de la chambre de combustion 81 , l'allumeur 82 étant alimenté par le conducteur électrique 83 à partir de la batterie 72, et la chambre de combustion tubulaire 81 de l'allumeur 79 débouchant par un convergent 84 dans une volute 85 ménagée à l'intérieur du bourrelet externe 29' entourant l'entrée annulaire 30 d'air d'admission du compresseur BP 15 de la microturbine, de sorte qu'un flux de gaz résultant de la combustion du propergol solide est dirigé par le convergent 84, la volute 85 et des entrées 86 dans la paroi radiale d'extrémité axiale 27 du carter de la microturbine, de sorte à entraîner la rotation du rotor 3 de l'étage BP 1. En particulier, l'intérieur de la volute 85 est relié à l'intérieur du carter externe de la microturbine par des entrées quasi-tangentielles 86, discrètes, traversant ce carter et débouchant dans le canal de la roue-de compresseur BP 7, de façon à communiquer un couple moteur au rotor 3 de l'étage BP 1.

Tant que les conditions nominales de pression ne sont pas atteintes, le microclapet ou vanne 74, qui règle le débit du flux d'air comprimé BP vers la turbine 61 du turbogénérateur 68, reste fermé afin de faciliter le démarrage de la microturbine.

En variante, une cartouche d' air comprimé peut être substituée à la cartouche de propergol solide 80 dans un démarreur à air comprimé substituable et de préférence interchangeable avec le démarreur à générateur de gaz 79.

Lorsqu'une utilisation sous forme pneumatique de la puissance utile disponible sur la turbine de puissance BP 17 est préférée, pour certaines applications, on note que l'on dispose directement d'air comprimé grâce au flux d'air comprimé BP transmis dans le conduit 60. Ce conduit 60 peut alors être aménagé en volute enveloppant extérieurement le carter 5 de l'étage BP 1 pour la collecte de l'air comprimé de travail dans un conduit, de type tuyau, pour raccordement vers l'utilisation pneumatique.

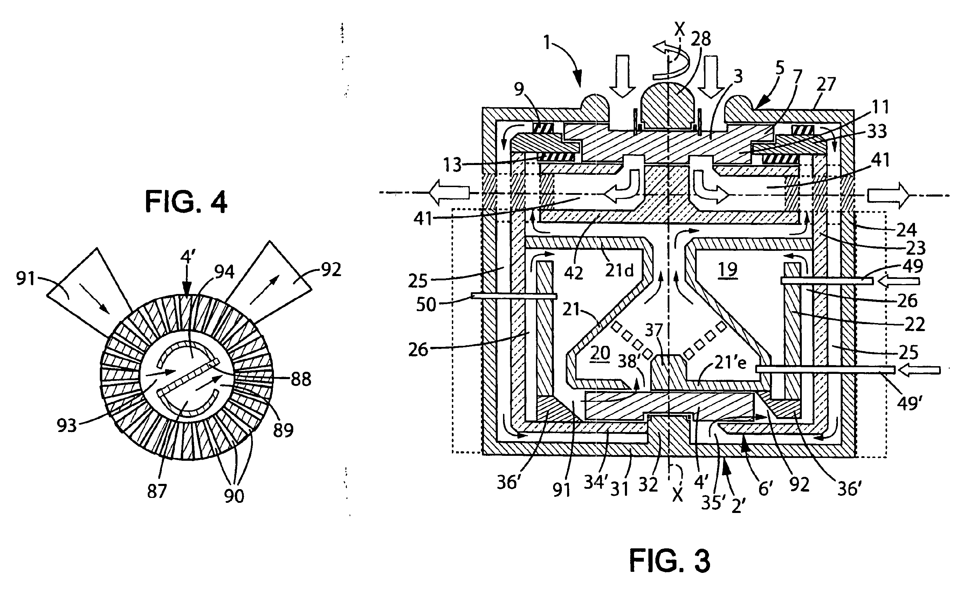

La figure 3 représente une variante de la microturbine de la figure 1, dans laquelle seul l'étage HP a été modifié, de sorte que les autres parties et composants de la microturbine sont repérés sur la figure 3 par les mêmes références numériques que sur la figure 1, et fonctionnent de la même manière, et ne sont pas à nouveau décrits.

Sur la figure 3, les moyens de compression de gaz et les moyens de détente de gaz de l'étage HP 2' ne sont plus constitués respectivement par un compresseur centrifuge HP tel que 16 associé à un diffuseur annulaire tel que 10 et par une turbine centripète HP telle que 18 associée à un distributeur annulaire tel que 14 sur la figure 1, avec un rotor 4 solidarisant la roue de compresseur centrifuge HP 8 et la roue de turbine centripète HP 12, mais par un dispositif dénommé compresseur-détendeur à ondes, ou « rotor à ondes » (dénommé en anglais « wave rotor »), ou encore parfois dénommé « échangeur de pression », qui comprend un rotor cylindrique rotatif autour de son axe dans un carter cylindrique coaxial entourant le rotor, et présentant en général quatre portes ou ouvertures fixes dans le carter, en regard desquelles défilent des canaux ménagés dans le rotor et ainsi alternativement ouverts et fermés à leurs extrémités, lorsque le rotor tourne dans son carter, de sorte que de l'air, admis par une porte d'entrée d'air d'admission, est mis en contact direct avec des gaz chauds et comprimés, admis par une porte d'entrée d'admission des gaz, et qu'un transfert d'énergie s'effectue à l'intérieur des canaux du rotor par déplacement d'ondes de détente et d'ondes de compression respectivement dans les gaz chaud et dans l'air en contact direct dans les canaux, de sorte que de l'air comprimé sort des canaux par une porte de sortie d'air comprimé, et que les gaz détendus s'échappent par une porte de sortie de ces derniers. Les compresseurs-détendeurs à ondes ou « rotors à ondes » sont des dispositifs connus, basés sur les brevets allemand et suisses précités ainsi que sur les brevets US cités ci-après, et dont des réalisations avec des portes d'entrée et de sortie d'air et de gaz chaud ménagées dans les deux faces radiales d'extrémité du rotor cylindrique sont commercialisées sous la marque enregistrée COMPREX. Le compresseur-détendeur à ondes, également dénommé CODETON selon une appellation française, a également fait l'objet d'une présentation dans un article intitulé : « Compresseur-détendeur à ondes (CODETON) pour turbines à gaz et turboréacteurs » de Yves RIBAUD & Véronique QUINTILLA, NOUVELLE REVUE D'AERONAUTIQUE ET D'ASTRONAUTIQUE, N°5-1998, et des développements de structure et d'application du compresseur-détendeur à ondes ont fait l'objet de nombreux brevets, parmi lesquels on peut citer les brevets US 3 879 937, US 4 288 203, US 4 971 524, US 5 052 895, US 5 522 217, et US 5 894 719. Les compresseurs-détendeurs à ondes sont des composants déjà proposés pour améliorer les performances des turbines à gaz et assurer la suralimentation des moteurs à combustion interne, en remplacement d'un turbo compresseur classique.

Bien que, généralement, les canaux ou cellules dans lesquels le transfert d'énergie entre compression et détente s'effectue par contact direct entre de l'air et des gaz chauds et comprimés soient des canaux ou cellules essentiellement axiaux (canaux droits parallèles à l'axe du rotor ou canaux cintrés mais débouchant dans les deux faces radiales d'extrémité du rotor), il a récemment été proposé que les canaux ou cellules s'étendent essentiellement radialement dans un rotor en forme générale de roue cylindrique, avec en général deux portes décalées l'une de l'autre en direction circonférentielle dans une paroi, en position radiale interne vis-à-vis du rotor, d'un carter statorique, et généralement deux portes décalées l'une de l'autre en direction circonférentielle dans une paroi, en position radiale externe vis-à-vis du rotor, du carter statorique, de sorte que les canaux essentiellement radiaux (canaux rectilignes ou cintrés en portion de spirale) soient alternativement ouverts et fermés à leurs extrémités radiales interne et externe, les ouvertures s'effectuant par mise en regard avec les portes ménagées en positions fixes dans les parois interne et externe du carter statorique par des lumières pratiquées dans ces parois. Ces portes, généralement au nombre de quatre, assurent, comme dans un étage compression/détente à turbomachines, le raccordement fluide avec le reste de l'installation, par une entrée d'air d'admission, une sortie d'air comprimé reliée à une chambre de combustion, une entrée d'admission des gaz brûlés provenant de la sortie de la chambre de combustion, et une sortie d'échappement des gaz brûlés une fois détendus dans les canaux essentiellement radiaux, et dirigés vers un détendeur, telle qu'une turbine par exemple. Un tel « rotor à ondes » radial a notamment fait l'objet de la publication intitulée « NUMERICAL SIMULATION OF UNSTEADY-FLOW PROCESSES IN WAVE ROTORS », dans les « Proceedings of IMECE04, 2004 ASME International Mechanical Engineering Congress, November 13-19, 2004 Anaheim, California USA » (IMECE2004-60973).

Dans la variante de la figure 3, un tel « rotor à ondes » radial, dont le rotor 4' et les quatre portes du carter statorique 6' sont schématiquement représentés sur la figure 4, est utilisé comme étage HP 2' à la place de l'étage HP 2 à turbocompresseur de la figure 1.

Dans la variante des figures 3 et 4, l'air comprimé BP, provenant par le conduit externe 25 de la sortie du compresseur centrifuge BP 15, est admis par l'entrée axiale 35', ménagée dans la paroi radiale thermiquement isolante 34' uniquement sur une partie de la périphérie du corps central 32 de la paroi radiale d'extrémité thermiquement conductrice 31, de sorte à communiquer avec la chambre radiale interne 87 (voir figure 4) délimitée d'un côté d'une paroi 88 en forme générale de Z arrondi, en un matériau thermiquement isolant, et fixée non rotative radialement à l'intérieur du rotor annulaire 4', cette chambre 87 s'ouvrant par une porte 89 vers les canaux 90 radiaux traversant le rotor 4', et dans lesquels l'air comprimé BP subit une nouvelle compression par contact direct avec les gaz d'échappement chauds et sous pression, provenant de la sortie de la chambre de combustion principale 19, et entrant dans les canaux radiaux 90 du rotor 4' par une porte 91 qui ne s'étend dans le carter 6' que sur une partie de la périphérie radiale externe du rotor 4', de sorte que l'air comprimé HP sort des canaux 90 du rotor 4' par une porte 92, limitée dans le carter 6' à une autre partie de la périphérie radiale externe du rotor 4', et débouchant dans le conduit annulaire 26 d'air comprimé HP guidé vers l'entrée de la chambre de combustion principale 19, et que les gaz chauds entrés par la porte 91 dans les canaux 90 du rotor 4' sortent détendus et refroidis par une porte 93, s'étendant sur une autre partie de la périphérie radiale interne du rotor 4', vers une chambre 94 radiale interne de l'autre côté de la paroi en Z 88 du carter statorique, d'où ces gaz chauds détendus s'échappent par une sortie axiale 38', qui ne s'étend que sur une partie de la périphérie du corps central 37 conducteur, solidaire de la paroi radiale conductrice 21'e, vers l'entrée de la chambre de combustion secondaire 20, dans laquelle ces gaz sont réchauffés, comme décrits en référence à la figure 1, pour être ensuite guidés vers la turbine centripète BP 17 ou turbine de puissance, dans laquelle ces gaz se détendent avant de s'échapper vers l'atmosphère ambiante.

Sur la figure 3, dans le carter 6' de l'étage HP 2' logeant le rotor à ondes 4', afin de limiter l'extension en direction circonférentielle de la porte de sortie 92 de l'air comprimé HP sortant des canaux radiaux 90 et de la porte d'entrée 91 des gaz brûlés sortant de la chambre de combustion principale 19 et entrant dans les canaux radiaux 90 du rotor 4', le flasque radial annulaire 36', solidaire de l'extrémité axiale de la paroi interne conductrice 22 à son extrémité tournée vers le rotor à ondes 4', est solidaire de la paroi radiale conductrice 21'e, sauf au niveau de la porte d'entrée 91, d'une part, et, d'autre part, solidaire de la paroi radiale isolante 34', sauf au niveau de la porte de sortie 92. De même, pour délimiter les ouvertures axiales d'entrée 35' et de sortie 38', respectivement vers la chambre 87 et à partir de la chambre 93 délimitées par la cloison radiale interne en Z 88 fixe à l'intérieur du rotor 4', la paroi radiale isolante 34' est en contact avec la périphérie du corps central 32 sauf au niveau de l'entrée axiale 35', et la paroi radiale conductrice 21'e est en contact avec le corps central conducteur 37 sur la périphérie de ce dernier sauf au niveau de la sortie axiale 38'.

Bien entendu, dans cette configuration, le rotor à ondes 4' intégré dans l'étage haute pression 2' apporte les avantages qui lui sont propres, en particulier de simplicité de construction et d'efficacité.

## Revendications

1. Machine thermique comprenant .
- deux rotors (3,4,4') indépendants, préférentiellement coaxiaux (XX), montés chacun dans l'un respectivement de deux carters (5,6,6'), le premier rotor (3) appartenant à un étage basse pression (1), le second rotor (4, 4') appartenant à un étage haute pression (2,2'), chaque étage (1,2,2') muni de son rotor (3,4,4') et d'organes fixes (9,10,13,14,89,91,92,93) associés de préparation de fluide combinant des moyens de compression de gaz, dits compresseur (15,16,90), et des moyens de détente de gaz, dits détendeur (17,18,90), et au moins une chambre de combustion (19,20), **caractérisée en ce que** ladite au moins une chambre de combustion est située dans un volume central sensiblement cylindrique délimité
- à ses bases, par les deux rotors (3,4,4') et leurs carters (5,6,6'), et
- à sa surface latérale, par une première paroi (22), sensiblement cylindrique et en position radiale interne,
ladite première paroi étant sensiblement coaxiale à une deuxième paroi (23), sensiblement cylindrique et en position radiale intermédiaire, lesdites première et deuxième parois définissant entre elles un premier conduit (26) reliant la sortie du compresseur (16,90) de l'étage haute pression à l'entrée d'une première chambre de combustion (19)
et ladite deuxième paroi (23) étant sensiblement coaxiale à une troisième paroi (24), sensiblement cylindrique et en position radiale externe, lesdites deuxième et troisième parois définissant entre elles un second conduit (25), extérieur au premier conduit (26) et reliant la sortie du compresseur (15) de l'étage basse pression (1) à l'entrée du compresseur (16,90) de l'étage haute pression (2,2'),
la sortie de la première chambre de combustion (19) alimentant le détendeur (18,90) de l'étage haute pression (2,2') en gaz produits de combustion, guidés de la sortie du détendeur (18, 90) de l'étage haute pression (2, 2') à l'entrée du détendeur (17) de l'étage basse pression (1), dont la sortie est en communication avec l'extérieur d'un carter (24,27,31) de la machine par au moins une ouverture (41) d'échappement des gaz produits de combustion.

2. Machine thermique selon la revendication 1, dans laquelle le carter (24-27-31) de la machine, qui comprend la troisième paroi (24) délimitant radialement vers l'extérieur le second conduit (25), annulaire et externe de circulation d'un gaz, tel que de l'air, comprimé basse pression, est réalisé en matériau thermiquement conducteur, et, de préférence, est muni d'ailettes (48) et/ou de picots (48') sur sa face externe et/ou interne.

3. Machine thermique selon l'une des revendications 1 et 2, dans laquelle le premier conduit (26), annulaire et interne de circulation de gaz, tel que de l'air, comprimé à haute pression, est délimité entre la deuxième paroi (23), agencée en carter intermédiaire en un matériau thermiquement isolant, radialement vers l'extérieur et le séparant du second conduit (25), et, radialement vers l'intérieur, la première paroi (22) agencée en carter interne en un matériau thermiquement conducteur, le séparant de la première chambre de combustion (19).

4. Machine thermique selon l'une quelconque des revendications 1 à 3, dans laquelle l'échappement vers l'extérieur des gaz issus du détendeur (17) de l'étage basse pression (1) est assuré par des conduits (41) discrets rayonnant sensiblement radialement vers l'extérieur par rapport à l'axe (XX) du premier rotor (3).

5. Machine thermique selon l'une quelconque des revendications 1 à 4, comprenant deux chambres de combustion (19,20) logées dans le volume central entre les deux rotors (3 ,4), et dont la première chambre de combustion, dite chambre de combustion principale (19), alimentée en gaz, tel que de l'air, comprimé haute pression sortant du compresseur (16) de l'étage haute pression (2) par le premier conduit (26), est convergente sensiblement dans la direction de l'axe (XX) du second rotor (4), vers l'entrée du détendeur (18) de l'étage haute pression (2), dont la sortie (38) débouche dans l'entrée de la deuxième chambre de combustion, dite chambre de combustion secondaire (20), entourée par la première chambre de combustion (19) annulaire, et qui converge axialement vers sa sortie reliée radialement vers l'extérieur à l'entrée du détendeur (17) de l'étage basse pression (1), la circulation des gaz dans les deux chambres de combustion (19,20) s'effectuant sensiblement axialement à contresens.

6. Machine thermique selon la revendication 5, telle que les deux chambres de combustion (19,20) sont séparées l'une de l'autre par une cloison centrale (21) sensiblement conique en un matériau thermiquement conducteur et conformée de sorte à délimiter les convergents à contre-courant des deux chambres de combustion (19,20).

7. Machine thermique selon la revendication 4, dans laquelle des conduits (41) d'échappement vers l'extérieur des gaz d'échappement issus du détendeur (17) de l'étage basse pression (1) sont délimités entre deux parois internes (39,42) sensiblement radiales et thermiquement isolantes, dont l'une (39) entoure la sortie (40) du détendeur (17) de l'étage basse pression (1) tandis que la seconde (42) dévie radialement vers l'extérieur les gaz produits de combustion issus de ladite au moins une chambre de combustion (19,20) et du détendeur (18) de l'étage haute pression (2).

8. Machine thermique selon l'une quelconque des revendications 1 à 7, dont le rapport des dimensions sensiblement radiale et axiale, par rapport à l'axe (XX) de l'un au moins des rotors (3,4), est voisin de 1.

9. Machine thermique selon l'une quelconque des revendications 1 à 8, dont l'étage basse pression (1) comporte le premier rotor (3) qui comprend, sur une face tournée vers l'extérieur de la machine, une roue aubée (7) de compresseur centrifuge (15) qui tourne radialement à l'intérieur d'un diffuseur (9) annulaire à aubes fixes par rapport au carter (5) du premier rotor (3), et, sur la face interne du premier rotor, une roue aubée (11) de turbine centripète (17), qui tourne radialement à l'intérieur d'un distributeur (13) annulaire centripète à aubes fixes par rapport au carter (5) du premier rotor (3), les roues (7,11) de compresseur (15) et de turbine (17) étant solidaires en rotation autour de leur axe (XX) commun, qui est l'axe du premier rotor (3).

10. Machine thermique selon la revendication 9, dont l'étage haute pression (2) présente une architecture analogue à celle de l'étage basse pression (1), les deux étages se présentant tête bêche, l'étage haute pression (2) comportant le second rotor (4) qui comprend, sur une face tournée vers l'extérieur de la machine, une roue aubée (8) de compresseur centrifuge (16) qui tourne radialement à l'intérieur d'un diffuseur (10) annulaire à aubes fixes par rapport au carter (6) du second rotor (4), et, sur la face interne du second rotor (4), une roue aubée (12) de turbine centripète (18), qui tourne radialement à l'intérieur d'un distributeur (14) annulaire centripète à aubes fixes par rapport au carter (6) du second rotor (4), les roues (8,12) de compresseur (16) et de turbine (18) étant solidaires en rotation autour de leur axe (XX) commun, qui est l'axe du second rotor (4).

11. Machine thermique selon la revendication 9, dont l'étage haute pression (2') comprend un compresseur-détendeur à ondes, dit « rotor à ondes », dans lequel un transfert d'énergie entre compression d'un gaz, tel que de l'air, et détente de gaz brûlés s'effectue à l'intérieur d'une roue (4') à canaux (90) par contact direct entre ledit gaz et lesdits gaz brûlés dans lesdits canaux (90) et par un processus basé sur le déplacement d'ondes de détente et d'ondes de compression dans lesdits canaux (90) de ladite roue (4') à canaux, ledit « rotor à ondes » comportant une entrée (89) de gaz (air) d'admission, une sortie (92) de gaz (air) comprimé, reliée à une première chambre de combustion (19), une entrée (91) d'admission des gaz brûlés provenant de la sortie de la première chambre de combustion (19), et une sortie (92) d'échappement desdits gaz brûlés; vers une deuxième chambre de combustion (20) le cas échéant et le détendeur (17) de l'étage basse pression (1).

12. Machine thermique selon l'une quelconque des revendications 1 à 11, dont les rotors (3,4) sont sustentés axialement et radialement par des paliers à gaz (44,45,46,47).

13. Machine thermique selon l'une quelconque des revendications 1 à 12, dans laquelle le carter (24-27-31) de la machine délimitant, radialement vers l'extérieur, le second conduit (25) est au moins partiellement plongé dans un réservoir d'eau (51) fermé étanche, de préférence à double paroi (52), destiné à la production de vapeur sous pression, et à isoler thermiquement la machine thermique de l'extérieur et faciliter son intégration dans un réceptacle qui lui est destiné.

14. Machine thermique selon la revendication 13, dans laquelle la vapeur d'eau produite dans une première chambre (56) du réservoir (51) a sa pression contrôlée par une soupape (58) de communication avec une deuxième chambre (54) du réservoir, elle-même en communication avec l'entrée du détendeur (17) de l'étage basse pression (1), de sorte à mélanger de la vapeur d'eau aux gaz produits de combustion issus de ladite au moins une chambre de combustion (19,20), avant leur passage dans le détendeur (17) de l'étage basse pression (1).

15. Machine thermique selon l'une des revendications 13 et 14, dans laquelle l'échappement des gaz et de la vapeur d'eau issus du détendeur (17) de l'étage basse pression (1) s'effectue par des conduits séparés (41), de préférence rayonnant sensiblement radialement, et prolongés (55) au travers du réservoir d'eau (51) avant de déboucher dans le milieu ambiant, de sorte à assurer un préchauffage de l'eau dans le réservoir (51).

16. Machine thermique selon l'une quelconque des revendications 1 à 15, dans laquelle le débit de gaz (air) issu du compresseur (15) de l'étage basse pression (1) est partagé en deux flux, dont l'un est dirigé vers le compresseur (16) de l'étage haute pression (2) et l'autre vers une utilisation (60), sous forme pneumatique, de la puissance utile.

17. Machine thermique selon la revendication 16, dans laquelle le flux de gaz (air) comprimé basse pression, correspondant à la puissance utile transmise par le compresseur (15) de l'étage basse pression (1), alimente une turbine (61) d'un turbo générateur (68), dont la génératrice électrique (65-66) alimente une batterie (72), reliée par au moins une sortie de puissance électrique (75) à au moins un consommateur électrique.

18. Machine thermique selon la revendication 17, dans laquelle le turbo générateur électrique (68) est isolé thermiquement (67) du carter de machine enveloppant les deux rotors (3,4), ladite au moins une chambre de combustion (19,20) et les conduits (25,26) de circulation de gaz (air) comprimé basse pression et haute pression et gaz produits de combustion basse pression et haute pression.

19. Machine thermique selon l'une quelconque des revendications 17 et 18, dans laquelle la génératrice électrique (65-66) du turbo générateur (68) est de type magnétique, comportant au moins un aimant permanent (65) monté sur une face d'une roue aubée (63) de turbine centripète (61) du turbo générateur (68), du côté opposé à la face présentant les aubes de la dite turbine centripète (61), ledit au moins un aimant permanent (65) étant solidaire en rotation de la roue de turbine (63) centripète du turbo générateur (68) et tournant en regard d'au moins une bobine plate (66) d'induit de la génératrice électrique (65-66).

20. Machine thermique selon l'une quelconque des revendications 17 à 19, dans laquelle la batterie (72) alimentée par la génératrice électrique (65-66) du turbo générateur (68) alimente elle-même au moins un allumeur électrique du mélange gaz (air)-combustible dans ladite au moins une chambre de combustion (19,20), dans laquelle du combustible est injecté par au moins un conduit (49,49') d'alimentation en combustible.

21. Machine thermique selon l'une quelconque des revendications 17 à 20, telle que rattachée à la revendication 13, dans laquelle la batterie (72) alimentée par la génératrice électrique (65-66) du turbo générateur (68) alimente elle-même au moins une résistance chauffante (77) disposée dans une chambre (56) du réservoir d'eau (51), pour produire de la vapeur d'eau sous pression alimentant le détendeur (17) de l'étage basse pression (1) pour démarrer la machine thermique à démarreur électrique à résistance chauffante (77).

22. Machine thermique selon la revendication 17, dans laquelle le flux de gaz (air) comprimé basse pression provenant du compresseur (15) de l'étage basse pression (1) alimente la turbine centripète (61) du turbo générateur (68) après ouverture d'un clapet (74), et de préférence au travers d'un distributeur (62) annulaire centripète à aubes fixes entourant la roue aubée (63) de ladite turbine centripète (61) du turbo générateur (68) ou au travers d'une volute entourant ladite turbine centripète (61) du turbo générateur (68).

23. Machine thermique selon l'une quelconque des revendications 1 à 22, équipée d'un démarreur (79) à propergol solide (80), dans lequel le démarreur (79) est agencé en générateur de gaz par allumage (82), de préférence électrique, à partir d'une batterie (72), du propergol solide (80), de sorte qu'un flux de gaz résultant de la combustion du propergol solide est dirigé, par au moins une entrée (86) dans une face radiale d'extrémité du carter de machine, de préférence autour d'une ouverture (30) d'entrée de gaz (air) d'admission dans la machine thermique, de sorte à entraîner la rotation du rotor (3) de l'étage basse pression (1).

24. Machine thermique selon la revendication 23, dans laquelle le démarreur (79) agencé en générateur de gaz reçoit une cartouche (80) de propergol solide mise en place pour chaque démarrage de la machine thermique, ledit générateur de gaz étant relié à l'intérieur du carter de la machine thermique par au moins une entrée quasi-tangentielle (86) de sorte à entraîner en rotation le rotor (3) de l'étage basse pression (1).

## Claims

1. Thermal engine comprising:
- two independent rotors (3,4,4'), preferably coaxial (XX), each respectively mounted in one of two casings (5,6,6'), the first rotor (3) belonging to a low pressure stage (1), the second rotor (4,4') belonging to a high pressure stage (2,2'), each stage (1,2,2') provided with its rotor (3,4,4') and associated fixed fluid preparation members (9,10,13,14,89,91,92,93) combining gas compression means, known as compressors (15,16,90), and gas expansion means, known as expanders (17,18,90), and at least one combustion chamber (19,20) **characterized in that** said at least one combustion chamber is situated within a substantially cylindrical central volume defined
. at its bases, by the two rotors (3,4,4') and their casings (5,6,6'), and
. at its lateral surface, by a first substantially cylindrical wall (22), in an inner radial position,
said first wall being substantially coaxial with a second substantially cylindrical wall (23) in an intermediate radial position, said first and second walls defining between them a first duct (26) connecting the outlet of the compressor (16,90) of the high pressure stage to the inlet of a first combustion chamber (19),
and said second wall (23) being substantially coaxial with a third substantially cylindrical wall (24) in an outer radial position, said second and third walls defining between them a second duct (25), outside the first duct (26) and connecting the outlet of the compressor (15) of the low pressure stage (1) to the inlet of the compressor (16,90) of the high pressure stage (2,2'),
the outlet of the first combustion chamber (19) supplying the expander (18,90) of the high pressure stage (2,2') with gases produced by combustion, guided from the outlet of the expander (18,90) of the high pressure stage (2,2') to the inlet of the expander (17) of the low pressure stage (1), the outlet of which is in communication with the outside of a casing (24,27,31) of the engine via at least one exhaust opening (41) for the gases produced by combustion.

2. Thermal engine according to Claim 1, in which the casing (24-27-31) of the engine, which comprises the third wall (24) defining radially towards the outside the second, annular, outer duct (25) for the flow of low pressure compressed gas, such as air, is made of thermally conductive material and, preferably, is provided with fins (48) and/or spikes (48') on its outer and/or inner face.

3. Thermal engine according to one of Claims 1 and 2, in which the first, annular, inner duct (26) for the flow of high pressure compressed gas, such as air, is defined between the second wall (23), arranged as an intermediate casing of a thermally insulating material, radially towards the outside and separating it from the second duct (25), and the first wall (22) arranged as an inner casing of a thermally conductive material, radially towards the inside and separating it from the first combustion chamber (19).

4. Thermal engine according to any one of Claims 1 to 3, in which exhaust towards the outside of the gases stemming from the expander (17) of the low pressure stage (1) is ensured by discrete ducts (41) extending substantially radially towards the outside relative to the axis (XX) of the first rotor (3).

5. Thermal engine according to any one of Claims 1 to 4, comprising two combustion chambers (19,20) accommodated in the central volume between the two rotors (3,4), of which the first combustion chamber, known as the main combustion chamber (19), supplied with high pressure compressed gas, such as air, exiting from the compressor (16) of the high pressure stage (2) via the first duct (26), converges substantially in the direction of the axis (XX) of the second rotor (4) towards the inlet of the expander (18) of the high pressure stage (2), whose outlet (38) leads into the inlet of the second combustion chamber, known as the secondary combustion chamber (20), surrounded by the first annular combustion chamber (19) and which converges axially towards its outlet connected radially towards the outside to the inlet of the expander (17) of the low pressure stage (1), flow of the gases in the two combustion chambers (19,20) taking place substantially axially in opposing directions.

6. Thermal engine according to Claim 5, such that the two combustion chambers (19,20) are separated from one another by a substantially conical central partition (21) of a thermally conductive material shaped so as to define the countercurrent convergent paths of the two combustion chambers (19,20).

7. Thermal engine according to Claim 4, in which ducts (41) exhausting towards the outside the exhaust gases stemming from the expander (17) of the low pressure stage (1) are defined between two substantially radial, thermally insulating inner walls (39,42), one (39) of which surrounds the outlet (40) of the expander (17) of the low pressure stage (1) while the second (42) diverts radially towards the outside the gases produced by combustion stemming from said at least one combustion chamber (19,20) and from the expander (18) of the high pressure stage (2).

8. Thermal engine according to any one of Claims 1 to 7, for which the ratio of the substantially radial and axial dimensions relative to the axis (XX) of one at least of the rotors (3,4) is around 1.

9. Thermal engine according to any one of Claims 1 to 8, the low pressure stage (1) of which comprises the first rotor (3), which comprises, on a face facing the outside of the engine, a bladed wheel (7) of a centrifugal compressor (15), which rotates radially inside an annular diffuser (9) with blades which are fixed relative to the casing (5) of the first rotor (3), and, on the inner face of the first rotor, a bladed wheel (11) of a centripetal turbine (17), which rotates radially inside an annular centripetal distributor (13) with blades which are fixed relative to the casing (5) of the first rotor (3), the wheels (7,11) of the compressor (15) and turbine (17) being connected for rotation around their common axis (XX), which is the axis of the first rotor (3).

10. Thermal engine according to Claim 9, the high pressure stage (2) of which has an architecture similar to that of the low pressure stage (1), the two stages being inverted relative to one another, the high pressure stage (2) comprising the second rotor (4), which comprises, on a face facing the outside of the engine, a bladed wheel (8) of a centrifugal compressor (16), which rotates radially inside an annular diffuser (10) with blades fixed relative to the casing (6) of the second rotor (4), and, on the inner face of the second rotor (4), a bladed wheel (12) of a centripetal turbine (18), which rotates radially inside an annular centripetal distributor (14) with blades fixed relative to the casing (6) of the second rotor (4), the wheels (8,12) of the compressor (16) and the turbine (18) being connected for rotation around their common axis (XX), which is the axis of the second rotor (4).

11. Thermal engine according to Claim 9, the high pressure stage (2') of which comprises a wave compressor-expander, known as a "wave rotor", in which a transfer of energy between compression of a gas such as air and expansion of combusted gases takes place inside a wheel (4') with channels (90) by direct contact between said gas and said combusted gases in said channels (90) and by a process based on the displacement of expansion waves and compression waves in said channels (90) of said channelled wheel (4'), said "wave rotor" comprising an inlet (89) for admission gas (air), an outlet (92) for compressed gas (air), connected to a first combustion chamber (19), an admission inlet (91) for the combusted gases stemming from the outlet of the first combustion chamber (19), and an exhaust outlet (92) for said combusted gases, towards a second combustion chamber (20), if applicable, and the expander (17) of the low pressure stage (1).

12. Thermal engine according to any one of Claims 1 to 11, of which the rotors (3,4) are supported axially and radially by gas bearings (44,45,46,47).

13. Thermal engine according to any one of Claims 1 to 12, in which the casing (24-27-31) of the engine defining, radially towards the outside, the second duct (25) is at least partially immersed in a preferably double-walled (52), impermeable, closed water tank (51), intended to produce pressurized steam and to insulate the thermal engine thermally from the outside and facilitate its integration in a receptacle designed therefor.

14. Thermal engine according to Claim 13, in which the steam produced in a first chamber (56) of the tank (51) has its pressure controlled by a valve (58) communicating with a second tank chamber (54), itself in communication with the inlet of the expander (17) of the low pressure stage (1), so as to mix steam with the gases produced by combustion stemming from said at least one combustion chamber (19,20), before passage thereof into the expander (17) of the low pressure stage (1).

15. Thermal engine according to one of Claims 13 and 14, in which the gases and steam stemming from the expander (17) of the low pressure stage (1) are exhausted via separate ducts (41), preferably extending substantially radially, and continuing (55) through the water tank (51) before emerging into the surrounding environment, so as to ensure preheating of the water in the tank (51).

16. Thermal engine according to any one of Claims 1 to 15, in which the stream of gas (air) stemming from the compressor (15) of the low pressure stage (1) is divided into two flows, one of which is directed towards the compressor (16) of the high pressure stage (2) and the other towards utilization (60), in pneumatic form, of the useful power.

17. Thermal engine according to Claim 16, in which the flow of low pressure compressed gas (air), corresponding to the useful power transmitted by the compressor (15) of the low pressure stage (1), supplies a turbine (61) of a turbogenerator (68), whose electric generator (65-66) supplies a battery (72), connected by at least one electrical power outlet (75) to at least one electrical consumer unit.

18. Thermal engine according to Claim 17, in which the electric turbogenerator (68) is thermally insulated (67) from the engine casing enclosing the two rotors (3,4), said at least one combustion chamber (19,20) and the ducts (25,26) for the flow of low pressure and high pressure compressed gas (air) and low pressure and high pressure gases produced by combustion.

19. Thermal engine according to either one of Claims 17 and 18, in which the electric generator (65-66) of the turbogenerator (68) is of magnetic type, comprising at least one permanent magnet (65) mounted on one face of a bladed wheel (63) of the centripetal turbine (61) of the turbogenerator (68), on the opposite side to the face having the blades of said centripetal turbine (61), said at least one permanent magnet (65) being connected for rotation to the centripetal turbine wheel (63) of the turbogenerator (68) and revolving opposite at least one flat armature coil (66) of the electric generator (65-66).

20. Thermal engine according to any one of Claims 17 to 19, in which the battery (72) supplied by the electric generator (65-66) of the turbogenerator (68) itself supplies at least one electrical ignition device for the gas (air)/fuel mixture in said at least one combustion chamber (19,20), into which fuel is injected via at least one fuel supply duct (49,49').

21. Thermal engine according to any one of Claims 17 to 20, as depending on Claim 13, in which the battery (72) supplied by the electric generator (65-66) of the turbogenerator (68) itself supplies at least one heating resistor (77) disposed in a chamber (56) of the water tank (51), to produce pressurized steam supplying the expander (17) of the low pressure stage (1) so as to start the thermal engine with electrical starter with heating resistor (77).

22. Thermal engine according to Claim 17, in which the flow of low pressure compressed gas (air) stemming from the compressor (15) of the low pressure stage (1) supplies the centripetal turbine (61) of the turbogenerator (68) after opening of a check valve (74), and preferably through an annular centripetal distributor (62) with fixed blades surrounding the bladed wheel (63) of said centripetal turbine (61) of the turbogenerator (68), or through a volute surrounding said centripetal turbine (61) of the turbogenerator (68).

23. Thermal engine according to any one of Claims 1 to 22, equipped with a starter (79) using solid propellant (80), in which the starter (79) is arranged as a gas generator by ignition (82), preferably electrical, by means of a battery (72), of the solid propellant (80), such that a gas flow resulting from combustion of the solid propellant is directed, via at least one inlet (86) in a radial end face of the engine casing, preferably around an admission gas (air) inlet opening (30) in the thermal engine, so as to bring about rotation of the rotor (3) of the low pressure stage (1).

24. Thermal engine according to Claim 23, in which the starter (79) arranged as a gas generator receives a solid propellant cartridge (80) provided for each start of the thermal engine, said gas generator being connected to the inside of the casing of the thermal engine via at least one quasi-tangential inlet (86) so as to set the rotor (3) of the low pressure stage (1) in rotation.

## Patentansprüche

1. Thermische Maschine, mit:
- zwei unabhängigen vorzugsweise koaxialen (XX) Rotoren (3, 4, 4'), wobei jeder in jeweils einem von zwei Gehäusen (5, 6, 6') montiert ist, der erste Rotor (3) zu einer Niedrigdruckstufe (1) gehört, der zweite Rotor (4, 4') zu einer Hochdruckstufe (2, 2') gehört, jede Stufe (1, 2, 2') mit seinem Rotor (3, 4, 4') und mit Fluidvorbereitung zusammenhängenden feststehenden Einrichtungen (9, 10, 13, 14, 89, 91, 92, 93) ausgebildet ist, die Verdichtungsmittel für Gas, die als Verdichter (15, 16, 90) bezeichnet werden, und ein Entspannungsmittel für Gas, das als Druckminderer (17, 18, 90) bezeichnet wird, kombinieren, und mindestens eine Brennkammer (19, 20), **dadurch gekennzeichnet, dass** die mindestens eine Brennkammer in einem zentralen im Wesentlichen zylindrischen Volumen angeordnet ist, das
- an seinen Grundseiten durch die zwei Rotoren (3, 4, 4') und ihre Gehäuse (5, 6, 6'), und
- an seiner Seitenfläche durch eine erste Wand (22) begrenzt ist, die im Wesentlichen zylindrisch und radial innen angeordnet ist,
wobei die erste Wand im Wesentlichen zu einer zweiten Wand (23) koaxial ist, die im Wesentlichen zylindrisch und radial mittig positioniert ist, die erste und zweite Wand zwischen sich einen ersten Kanal (26) definieren, der den Ausgang des Verdichters (16, 90) der Hochdruckstufe mit dem Eingang einer ersten Brennkammer (19) verbindet, und die zweite Wand (23) im Wesentlichen koaxial zu einer dritten Wand (24) ist, die im Wesentlichen zylindrisch und radial außen positioniert ist, wobei die zweite und dritte Wand zwischen sich einen zweiten Kanal (25) definieren, der zum ersten Kanal (26) außen liegt und den Ausgang des Verdichters (15) der Niedrigdruckstufe (1) mit dem Eingang des Verdichters (16, 90) der Hochdruckstufe (2, 2') verbindet,
wobei der Ausgang der ersten Brennkammer (19) den Druckminderer (18, 90) der Hochdruckstufe (2, 2') mit Verbrennungsabgasen versorgt, die von dem Ausgang des Druckminderers (18, 90) der Hochdruckstufe (2, 2') zum Eingang des Druckminderers (17) der Niedrigdruckstufe (1) geführt werden, dessen Ausgang mit der Außenseite eines Gehäuses (24, 27, 31) der Maschine über mindestens eine Auslassöffnung (41) für die Verbrennungsabgase verbunden ist.

2. Thermische Maschine nach Anspruch 1, in der das Gehäuse (24, 27, 31) der Maschine, das die dritte Wand (24) aufweist, die den ringförmigen und äußeren zweiten Kanal (25) für die Zirkulation eines niedrig verdichteten Gases, wie zum Beispiel Luft, radial nach Außen begrenzt, mit einem thermisch leitfähigen Material ausgebildet ist und bevorzugt mit Rippen (48) und/oder Zähnen (48') auf seiner äußeren und/oder inneren Seite ausgestattet ist.

3. Thermische Maschine nach Anspruch 1 oder 2, in der der ringförmige innere erste Kanal (26) für die Zirkulation eines hoch verdichteten Gases, wie zum Beispiel Luft, zwischen der zweiten Wand (23), die durch ein mittleres Gehäuse aus einem thermisch isolierenden Material ausgebildet ist und ihn radial nach Außen von dem zweiten Kanal (25) trennt, und der ersten Wand (22) beschränkt ist, die durch ein inneres Gehäuse aus einem thermisch leitenden Material ausgebildet ist und ihn radial nach Innen von der ersten Brennkammer (19) trennt.

4. Thermische Maschine nach einem der Ansprüche 1 bis 3, in der der Auslass der von dem Druckminderer (17) der Niedrigdruckstufe (1) nach Außen abgelassenen Gase über getrennte Kanäle (41) gesichert ist, die sich im Verhältnis zur Achse (XX) des ersten Rotors (3) im Wesentlichen radial nach außen erstrecken.

5. Thermische Maschine nach einem der Ansprüche 1 bis 4, mit zwei Brennkammern (19, 20), die in dem zentralen Volumen zwischen den zwei Rotoren (3, 4) angeordnet sind und deren erste Brennkammer, die als Hauptbrennkammer (19) bezeichnet wird und die mit hoch verdichtetem Gas, wie zum Beispiel Luft, versorgt wird, das über den ersten Kanal (26) aus dem Verdichter (16) der Hochdruckstufe (2) austritt, im Wesentlichen in Richtung der Achse (XX) des zweiten Rotors (4) in Richtung des Eingangs des Druckminderers (18) der Hochdruckstufe (2) konvergiert, dessen Ausgang (38) in den Eingang der zweiten Brennkammer mündet, die als sekundäre Brennkammer (20) bezeichnet wird und die durch die erste ringförmige Brennkammer (19) umgeben ist und die axial in Richtung ihres Ausgangs konvergiert, der radial nach Außen mit dem Eingang des Druckminderers (17) der Niedrigdruckstufe (1) verbunden ist und die Zirkulation des Gases in den zwei Brennkammern (19, 20) im Wesentlichen axial gegenläufig stattfindet.

6. Thermische Maschine nach Anspruch 5, bei der die zwei Brennkammern (19, 20) voneinander durch eine zentrale Trennwand (21) getrennt sind, die im Wesentlichen konisch aus einem thermisch leitfähigen Material und ausgebildet ist, um die konvergierenden Gegenströme der zwei Brennkammern (19, 20) zu begrenzen.

7. Thermische Maschine nach Anspruch 4, bei der Ablasskanäle (41) nach außen für Abgase, die von dem Druckminderer (17) der Niedrigdruckstufe (1) abgeleitet werden, zwischen zwei im Wesentlichen radialen und thermisch isolierenden Innenwänden (39, 42) begrenzt sind, von denen eine (39) den Ausgang (40) des Druckminderers (17) der Niedrigdruckstufe (1) umgibt, während die zweite (42) die Verbrennungsabgase radial nach Außen umleitet, die von der mindestens einen Brennkammer (19, 20) und dem Druckminderer (18) der Hochdruckstufe (2) abgegeben werden.

8. Thermische Maschine nach einem der Ansprüche 1 bis 7, bei der das Verhältnis der im Wesentlichen radialen und axialen Abmessungen im Verhältnis zur Achse (XX) von mindestens einem der Rotoren (3, 4) in etwa 1 ist.

9. Thermische Maschine nach einem der Ansprüche 1 bis 8, bei der die Niedrigdruckstufe (1) den ersten Rotor (3) aufweist, der auf einer zu der Maschine nach außen gerichteten Seite ein Schaufelrad (7) eines zentrifugalen Verdichters (15) aufweist, das sich radial innen zu einem im Verhältnis zum Gehäuse (5) des ersten Rotors (3) feststehenden ringförmigen Schaufeldiffuser (9) dreht, und auf der Innenseite des ersten Rotors ein Schaufelrad (11) einer Zentripetalturbine (17), die sich radial innen zu einem im Verhältnis zum Gehäuse (5) des ersten Rotors (3) feststehenden ringförmigen Zentripetalschaufelverteiler (13) dreht, wobei die Räder (7, 11) des Verdichters (15) und der Turbine (17) beim Drehen um ihre gemeinsame Achse (XX), die die Achse des ersten Rotors (3) ist, miteinander verbunden sind.

10. Thermische Maschine nach Anspruch 9, bei der die Hochdruckstufe (2) einen der Niedrigdruckstufe (1) entsprechenden Aufbau aufweist, die zwei Stufen entgegengesetzt zueinander ausgebildet sind und die Hochdruckstufe (2) den zweiten Rotor (4) aufweist, der auf einer zur Maschine nach Außen gerichteten Seite ein Schaufelrad (8) eines zentrifugalen Verdichters (16) aufweist, das sich radial innen zu einem im Verhältnis zum Gehäuse (6) des zweiten Rotors (4) feststehenden ringförmigen Schaufeldiffuser (10) dreht, und auf der Innenseite des zweiten Rotors (4) ein Schaufelrad (12) einer Zentripetalturbine (18), das sich radial innen zu einem im Verhältnis zu dem Gehäuse (6) des zweiten Rotors (4) feststehenden ringförmigen Zentripetalschaufelverteiler (14) dreht, wobei die Räder (8, 12) des Verdichters (16) und der Turbine (18) beim Drehen um ihre gemeinsame Achse (XX), die die Achse des zweiten Rotors (4) ist, verbunden sind.

11. Thermische Maschine nach Anspruch 9, bei der die Hochdruckstufe (2') einen Druckwellenverdichter-minderer aufweist, der als « Druckwellenrotor » bezeichnet wird, in dem eine Energieumwandlung zwischen einer Verdichtung eines Gases, wie zum Beispiel Luft, und Entspannung eines Abgases im Inneren eines Rads (4') mit Kanälen (90) über einen direkten Kontakt zwischen dem Gas und den Abgasen in den Kanälen (90) und über einen Prozess stattfindet, der auf der Versetzung der Druckminderungswellen und der Verdichtungswellen in den Kanälen (90) des Rads (Schiffer 4') mit Kanälen basiert, wobei der Druckwellenrotor einen Eingang (89) für einströmendes Gas (Luft), einen Ausgang (92) für verdichtetes Gas (Luft), der mit einer ersten Brennkammer (19) verbunden ist, einem Strömungseingang (91) für Abgas, das von dem Ausgang der ersten Brennkammer (19) ausgeht, und gegebenenfalls in Richtung einer zweiten Brennkammer (20) und in Richtung des Druckminderers (17) der Niedrigdruckstufe (1) einen Abgasauslass (92) für die Abgase aufweist.

12. Thermische Maschine nach einem der Ansprüche 1 bis 11, bei der die Rotoren (3, 4) axial und radial über aerostatische Lager (54, 45, 46, 47) unterstützt sind.

13. Thermische Maschine nach einem der Ansprüche 1 bis 12, bei der das Maschinengehäuse (24, 27, 31), das der zweite Kanal (25) radial nach außen begrenzt, zumindest teilweise in ein abgedichtetes geschlossenes Wasserreservoir (51), bevorzugt mit einer Doppelwand (52), eingetaucht ist, das für die Erzeugung von Dampf unter Druck und zum thermischen Isolieren der thermischen Maschine nach Außen vorgesehen ist und zum Vereinfachen seiner Integration in eine für ihn vorgesehene Aufnahme.

14. Thermische Maschine nach Anspruch 13, in der der Druck des in einer ersten Kammer (56) des Reservoirs (51) erzeugten Wasserdampfs über ein Ventil (58) in Verbindung mit einer zweiten Kammer (54) des Reservoirs kontrolliert wird, die wiederum mit dem Eingang des Druckminderers (17) der Niedrigdruckstufe (1) verbunden ist, um den Wasserdampf mit den Verbrennungsabgasen, die von der mindestens einen Brennkammer (19, 20) abgeleitet werden vor ihrem Durchgang durch den Druckminderer (17) der Niedrigdruckstufe (1) zu vermischen.

15. Thermische Maschine nach einem der Ansprüche 13 und 14, in der das Abführen des Gases und des Wasserdampfs, die von dem Druckminderer (17) der Niedrigdruckstufe (1) abgeleitet werden, durch getrennte Kanäle (41) ausgeführt wird, die sich bevorzugt im Wesentlichen radial erstrecken und sich durch das Wasserreservoir (51) hindurch ausdehnen (55) bevor sie in die Umgebung münden, um ein Vorwärmen des Wassers in dem Reservoir (51) sicherzustellen.

16. Thermische Maschine nach einem der Ansprüche 1 bis 15, in der der Ausstoß des Gases (Luft), das von dem Verdichter (15) der Niedrigdruckstufe (1) abgeleitet wird, in zwei Ströme aufgeteilt wird, von denen einer in Richtung des Verdichters (16) der Hochdruckstufe (2) geführt wird und der andere in pneumatischer Form zu einer Verwertung (60) der Nutzleistung.

17. Thermische Maschine nach Anspruch 16, in der der Strom des mit niedrigem Druck verdichteten Gases (Luft) der über den Verdichter (15) der Niedrigdruckstufe (1) übertragenen Nutzleistung entspricht, eine Turbine (61) eines Turbogenerators (68) versorgt, dessen elektrischer Generator (65-66) eine Batterie (72) versorgt, die über mindestens einen Ausgang für elektrische Leistung (75) mit mindestens einem elektrischen Verbraucher verbunden ist.

18. Thermische Maschine nach Anspruch 17, in der der elektrische Turbogenerator (68) thermisch (67) von dem Maschinengehäuse isoliert ist, das die zwei Rotoren (3, 4), die mindestens eine Brennkammer (19, 20) und die Kanäle (25, 26) zur Zirkulation des mit niedrigem Druck und hohem Druck verdichteten Gases (Luft) und der Verbrennungsgase niedrigen Drucks und hohen Drucks umschließt.

19. Thermische Maschine nach einem der Ansprüche 17 und 18, in der der elektrische Generator (65-66) des Turbogenerators (68) von magnetischer Typ ist, mit mindestens einem Permanentmagneten (65), der auf einer Seite eines Schaufelrads (63) der Zentripetalturbine (61) des Turbogenerators (68) montiert ist, und zwar auf der den Schaufeln der Zentripetalturbine (61) gegenüberstehenden Seite, wobei der mindestens eine Permanentmagnet (65) beim Drehen mit dem Zentripetalturbinenrad (63) des Turbogenerators (68) verbunden ist und sich im Verhältnis zu mindestens einer Induktionsflachspule (66) des elektrischen Generators (65-66) dreht.

20. Thermische Maschine nach einem der Ansprüche 17 bis 19, in der die durch den elektrischen Generator (65-66) des Turbogenerators (68) versorgte Batterie (72) wiederum mindestens eine elektrische Zündvorrichtung für eine Gas (Luft)-Brennstoffmischung in der mindestens einen Brennkammer (19, 20) versorgt, in die zur Brennstoffversorgung Brennstoff über mindestens einen Kanal (49, 49') eingespritzt wird.

21. Thermische Maschine nach einem der Ansprüche 17 bis 20, wenn abhängig von Anspruch 13, in der die durch den elektrischen Generator (65-66) des Turbogenerators (68) versorgte Batterie (72) wiederum mindestens einen in einer Kammer (56) des Wasserreservoirs (51) angeordneten Heizwiderstand (77) versorgt, um unter Druck Wasserdampf zu erzeugen, der den Druckminderer (17) der Niedrigdruckstufe (1) versorgt, um die thermische Maschine mit einem elektrischen Anlasser mit einem Heizwiderstand (77) zu starten.

22. Thermische Maschine nach Anspruch 17, in der der Strom des von dem Verdichter (15) der Niedrigdruckstufe (1) ausgehenden mit niedrigem Druck komprimierten Gases (Luft) die Zentripetalturbine (61) des Turbogenerators (68) nach Öffnung einer Klappe (74) versorgt und zwar bevorzugt durch einen feststehenden ringförmigen Zentripetalschaufelverteiler (62), der das Schaufelrad (63) der Zentripetalturbine (61) des Turbogenerators (68) umgibt, oder durch eine Spirale, die die Zentripetalturbine (61) des Turbogenerators (68) umgibt.

23. Thermische Maschine nach einem der Ansprüche 1 bis 22, die mit einem Anlasser (79) mit einem Festtreibstoff (80) ausgestattet ist, in der der Anlasser (79) in einem Gasgenerator mit einer bevorzugt von einer Batterie (72) ausgehenden elektrischen Zündung (82) des Festtreibstoffs (80) angeordnet ist, um einen durch die Verbrennung des Festtreibstoffs resultierenden Gasstrom über mindestens einen Eingang (86) in eine radiale Seite eines Maschinengehäuseendes geführt wird, und zwar bevorzugt um eine Eingangsöffnung (30) herum für in die thermische Maschine einströmendes Gas (Luft), um die Drehung des Rotors (3) der Niedrigdruckstufe (1) anzutreiben.

24. Thermische Maschine nach Anspruch 23, in der der in dem Gasgenerator angeordnete Anlasser (79) eine Patrone (80) des Festtreibstoffs aufnimmt, die für jeden Start der thermischen Maschine eingesetzt wird, wobei der Gasgenerator über mindestens einen quasi-tangentiellen Eingang (86) mit dem Inneren des Gehäuses der thermischen Maschine verbunden ist, um den Rotor (3) der Niedrigdruckstufe (1) anzutreiben.
